# EUROPÄISCHE PATENTANMELDUNG

(11) **EP 2 903 044 A1**
(43) Veröffentlichungstag der Anmeldung: **05.08.2015**
(21) Anmeldenummer: 14184773.1
(22) Anmeldetag: 15.09.2014
(51) Int. Cl.: H01L 51/00

(54) **Organische Moleküle zur Verwendung in optoelektronischen Bauelementen**

(30) Priorität: 04.02.2014 EP 14153893
(71) Anmelder: cynora GmbH, 76646 Bruchsal (DE)
(72) Erfinder: Danz, Michael, 76344 Eggenstein-Leopoldshafen (DE); Volz, Daniel, 76137 Karlsruhe (DE); Baumann, Thomas, 76133 Karlsruhe (DE)
(74) Vertreter: Hoppe, Georg Johannes

(57) **Zusammenfassung**

Die Erfindung betrifft neue organische Moleküle der Formel A zur Verwendung in optoelektronischen Bauelementen, insbesondere in OLEDs. 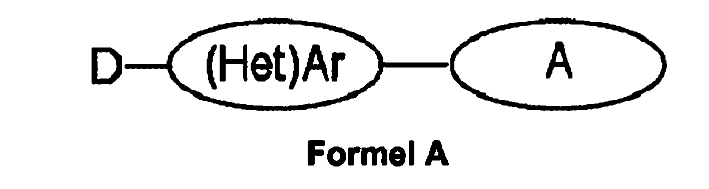 (Het)Ar = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen,
D = eine chemisch gebundene Donatorgruppe mit elektronenschiebenden Eigenschaften und
A = ein unsubstituierter oder substituierter 5- oder 6-gliedriger Ring optional mit mindestens einem Heteroatom, der aus einer [i+j]-Cycloaddition im Falle eines 5-Rings aus einem Dipolarophil und einem 1,3-Dipol und im Fall eines 6-Rings aus einem Dien und einem Dienophil gebildet werden kann.

## Beschreibung

Die Erfindung betrifft neue organische Moleküle sowie deren Verwendung in optoelektronischen Bauelementen, insbesondere in organischen lichtemittierenden Dioden (OLEDs).

### Stand der Technik

In den letzten Jahren hat sich die auf OLED (Organic Light Emitting Diodes) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik.

Aus diesem Grund wird bezüglich der Entwicklung neuer Materialien intensive Forschung betrieben. Obwohl eine OLED generell aus mehreren Schichten aufgebaut ist und für all diese ein Bedarf nach optimierten Materialien vorhanden ist, bildet dennoch die Emitterschicht (EML: *emitting layer*) das Kernstück einer solchen Bauteils, welche aus dem eigentlichen Emitter, welcher letztendlich die elektrische Energie in Photonen umwandelt, und optional Wirtsmolekülen (hosts) besteht.

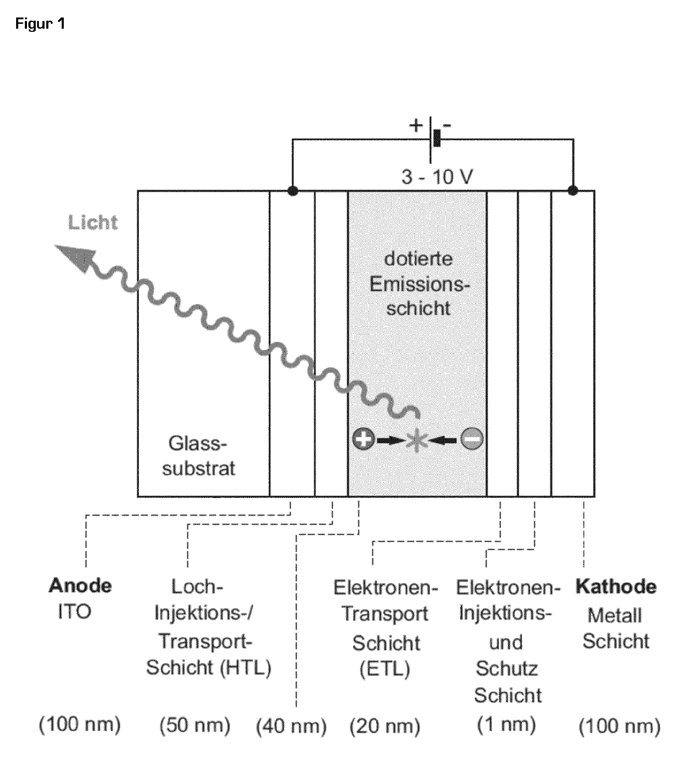

Derartige Bauteile sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25% der Exzitonen in Licht umwandeln konnten, konnte durch die Verwendung von phosphoreszierenden Verbindungen dieses grundsätzliche Problem umgangen werden, so dass theoretisch alle Exzitonen in Licht umgewandelt werden können. Diese Materialien zeigen jedoch gewisse Nachteile, vor allem bezüglich Kosten und Stabilität der verwendeten Materialien.

Bei den für das Triplett-Harvesting geeigneten Triplett-Emittern werden in der Regel Übergangsmetall-Komplexverbindungen eingesetzt, in denen das Metall aus der dritten Periode der Übergangsmetalle gewählt wird. Hierbei handelt es sich vorwiegend um sehr teure Edelmetalle wie Iridium, Platin oder auch Gold. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422).

In den letzten Dekaden hat eine stetige Weiterentwicklung dieser Emittermaterialen stattgefunden, wobei auch immer wieder neue Konzepte entwickelt wurden, um den hohen Preis und die Seltenheit von Edelmetallen zu umgehen. Angefangen bei rein fluoreszenten organischen Molekülen über Schwermetallkomplexe, insbesondere Iridium und Platin (triplet harvesting), geht die Entwicklung heutzutage in Richtung des Ausnutzens verzögerter Fluoreszenz (TADF: *thermally activated delayed fluorescence* oder auch *singlet harvesting).* Hierbei können beispielsweise Cu(I)-Komplexe verwendet werden, die aufgrund eines geringen ΔE_{ST} Triplett-Exitonen thermisch in einen Singulett-Zustand rückbesetzen können. Neben der Verwendung von Übergangsmetallkomplexen können auch rein organische Moleküle (ohne Metallion) diesen Effekt ausnutzen.

Die intensive Forschung in diesem Bereich zeigt, dass es trotz einiger bereits bestehender Konzepte für derartige Emittermaterialien weiterhin einen großen Bedarf an neuen Materialien gibt. Unter anderem ist hierfür ursächlich, dass es sowohl unterschiedliche Anwendungsbereiche (Bildschirmtechnologie, Beleuchtung, smarte Verpackungen usw.) als auch Herstellungsweisen (Vakuum, Flüssig oder hybride Prozessierungen) gibt. Besonders für den Bereich der Flüssigprozessierung muss ebenso die gezielte Löslichkeit bzw. Unlöslichkeit in speziellen Lösungsmitteln beachtet werden (Orthogonalität), damit Schichten nachfolgend aufgebracht werden können, ohne dass sich die zuvor abgeschiedene Schicht wieder anlöst. Neben den erwähnten Eigenschaften dieser Materialien ist für eine Kommerzialisierung ebenso die Zugänglichkeit relevant. Dies schließt sowohl die Verfügbarkeit von Synthesebausteinen, als auch den Aufwand für die eigentliche Synthese des funktionellen Materials, insbesondere dessen Aufreinigung mit ein.

### Beschreibung der Erfindung

Allgemein betrifft die Erfindung rein organische Moleküle (Farbstoffe) und deren Verwendung als Emitter in OLEDs (organic light emitting diodes) und in anderen opto-elektronischen Bauelementen.

Die Erfindung betrifft in einem Aspekt organische Moleküle umfassend oder bestehend aus einer chemischen Struktur nach Formel A (Farbstoffe, Emitter-Moleküle).

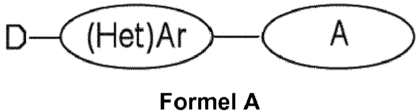

In Formel A stellt (Het)Ar eine konjugierte organische Gruppe, die ausgewählt ist aus der Gruppe bestehend aus unsubstituierten und substituierten aromatischen, heteroaromatischen und konjugierten, gegenüber cis-trans-Isomerisierung fixierten Doppelbindungen, dar.

Bei D handelt es sich um eine chemisch gebundene Donatorgruppe mit elektronenschiebenden Eigenschaften und A ist ein unsubstituierter oder substituierter 5- oder 6-gliederiger Ring, der aus einer [i+j]-Cycloaddition im Falle eines 5-Rings aus einem Dipolarophil und einem 1,3-Dipol und im Fall eines 6-Rings aus einem Dien und einem Dienophil gebildet werden kann, wobei A in einer Ausführungsform mindestens einem Heteroatom enthält.

Bei einer [i+j]-Cycloaddition werden jeweils i und j aneinanderhängende Atome der reagierenden Spezies zu einem Ringsystem mit insgesamt i + j Atomen verknüpft.

In einer bevorzugten Ausführungsform sind D und A an nicht benachbarte Atome der Gruppe (Het)Ar gebunden.

In einer weiteren Ausführungsform liegt das organische Molekül der Formel A als dimeres System vor, in dem die zwei gleichen oder verschiedenen Ringe A und A' durch einen Spacer verbrückt, der ein substituiertes oder unsubstituiertes aromatisches oder heteroaromatisches Ringsystem mit 5 bis 60 aromatischen Ringatomen ist. Es ergibt sich somit ein Dimer der Formel A*.

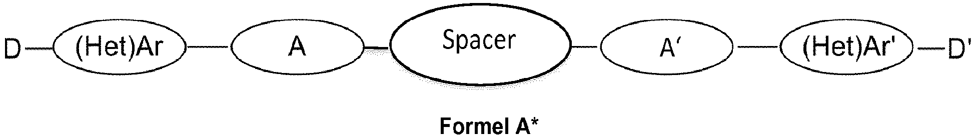

In Formel A* gilt:
(Het)Ar = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen,
(Het)Ar' = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen, die gleich oder verschieden sein kann zu (Het)Ar,
D und D' = unabhängig voneinander eine chemisch gebundene Donatorgruppe mit elektronenschiebenden Eigenschaften und
A und A' = unabhängig von einander ein unsubstituierter oder substituierter 5- oder 6-gliederiger Ring, der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und
Spacer = ein substituiertes oder unsubstituiertes aromatisches oder heteroaromatisches Ringsystem mit 5 bis 60 aromatischen Ringatomen wobei A und/oder A' in einer Ausführungsform mindestens einem Heteroatom enthält.

In einer bevorzugten Ausführungsform sind A und D nicht an direkt benachbarten Atomen der Gruppe (Het)Ar gebunden und A' und D' nicht an direkt benachbarten Atomen der Gruppe (Het)Ar' gebunden.

In einer weiteren bevorzugten Ausführungsform sind A gleich A', D gleich D' und (Het)Ar gleich (Het) Ar'.

Die Erfindung betrifft auch organische Moleküle gemäß Formel A in denen an die Einheit A eine Einheit (Het)Ar' und an diese wiederum eine Einheit D' gebunden ist, so dass diese organische Moleküle eine Struktur der Formel A' aufweisen.

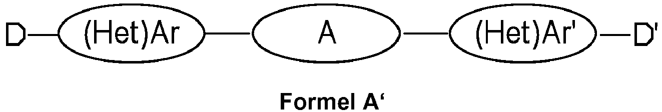

In Formel A' ist (Het)Ar eine konjugierte organische Gruppe, die ausgewählt ist aus der Gruppe bestehend aus unsubstituierten und substituierten aromatischen, heteroaromatischen und konjugierten, gegenüber cis-trans-Isomerisierung fixierten Doppelbindungen.

(Het)Ar' ist eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen, die gleich oder verschieden, in einer Ausführungsform gleich, sein kann zu (Het)Ar.

D und D' sind unabhängig voneinander eine chemisch gebundene Donatorgruppe mit elektronenschiebenden Eigenschaften, wobei D und D' in einer Ausführungsform gleich sind.

A steht für einen unsubstituierten oder substituierten 5- oder 6-gliederigen Ring, der in einer optional mindestens einem Heteroatom aufweist, der aus einer [i+j]-Cycloaddition im Falle eines 5-Rings aus einem Dipolarophil und einem 1,3-Dipol und im Fall eines 6-Rings aus einem Dien und einem Dienophil gebildet werden kann, wobei A und D bevorzugt nicht an direkt benachbarten Atomen der Gruppe (Het)Ar gebunden sind und wobei A und D' bevorzugt nicht an direkt benachbarten Atomen der Gruppe (Het)Ar' gebunden sind.

Eine Ausführungsform der Erfindung betrifft organischen Moleküle, welche
- einen ΔE(S₁-T₁)-Wert zwischen dem untersten angeregten Singulett (S₁)- und dem darunter liegenden Triplett (T₁)-Zustand von kleiner als 5000 cm⁻¹, bevorzugt kleiner als 3000 cm⁻¹ aufweisen und/oder
- eine Emissionslebensdauer von höchstens 50 µs aufweisen.

In einer Ausführungsform weisen (Het)Ar, (Het)Ar', A, A' D und/oder D' mindestens einen Substituenten zur Erhöhung der Löslichkeit des organischen Moleküls in einem organischen Lösungsmittel auf, wobei der Substituenten zur Erhöhung der Löslichkeit bevorzugt ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
- verzweigten oder unverzweigten oder zyklischen langkettigen Perfluoralkylketten einer Länge von C1 bis C30, und
- kurzkettigen Polyethern mit einer Kettenlänge von 3 bis 50 Wiederholungseinheiten.

In einer weiteren Ausführungsform ist (Het)Ar und (Het)Ar' unabhängig voneinander ein substituierter oder unsubstituierter Phenylring.

Bevorzugt sind bei den erfindungsgemäßen organischen Molekülen solche, bei denen mindestens einer der Substituenten A, A', D oder D' ein Heteroatom X aufweist, über das der Substituent kovalent an (Het)Ar bzw. (Het)Ar' gebunden ist, wobei das Heteroatom insbesondere ausgewählt ist aus der Gruppe bestehend aus N, O, P, S, Se.

In einer Ausführungsform der Erfindung handelt es sich bei dem organischen Molekül um ein organisches Molekül, aufweisend eine Struktur der Formel C.

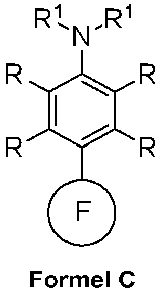

F ist ein unsubstituierter oder substituierter 5- oder 6-gliederiger Ring, welcher optional Heteroatome enthält und der aus einer [i+j]-Cycloaddition im Falle eines 5-Rings aus einem Dipolarophil und einem 1,3-Dipol und im Fall eines 6-Rings aus einem Dien und einem Dienophil gebildet werden kann. F ist ausgewählt ist aus der Gruppe bestehend aus 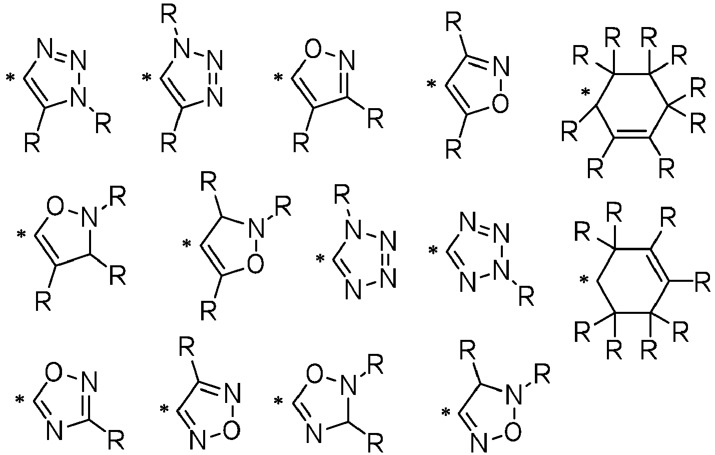 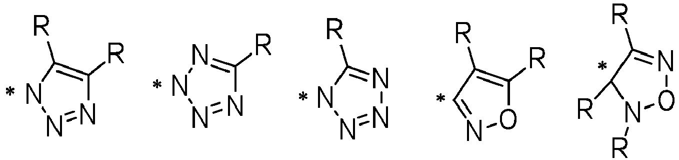 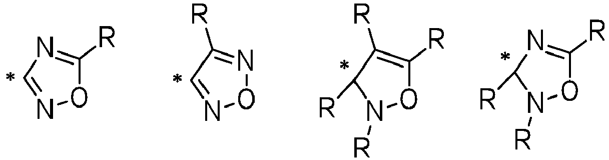 wobei
jedes R und R¹ bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R¹ auch miteinander ein mono- oder polycyclisches, aliphatisches, aromatisches und/oder benzoannelliertes Ringsystem bilden; R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(_{R}³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
und die Verknüpfung zur Phenyleinheit an der mit * markierten Stelle stattfindet.

In einer Ausführungsform ist an die Gruppe F eine weitere mit einer NR¹₂-Gruppe substituierte Phenyleinheit gebunden, so dass das organische Molekül eine Struktur der Formel C' aufweist, 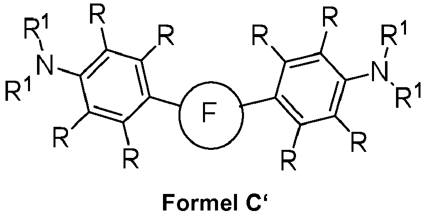 Bei F in Formel C' handelt es sich um einen unsubstituierten oder substituierten 5- oder 6-gliederigen Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 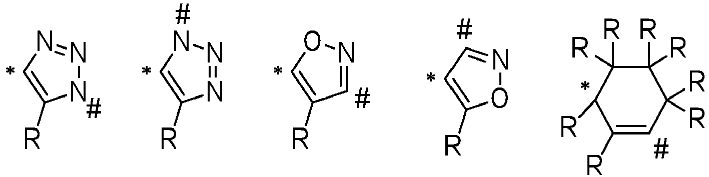 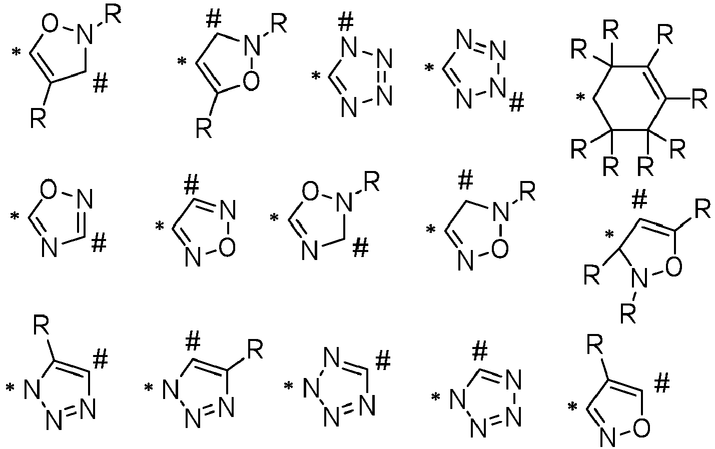 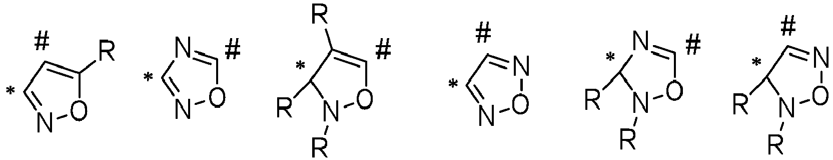 wobei jedes R und R¹ bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit
5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(_{R}³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
und die Verknüpfung zu den Phenyleinheiten an den mit * und # markierten Stellen stattfindet.

In einer Ausführungsform liegt das organische Molekül als ein über einen Spacer verbrücktes Dimer vor und weist eine Struktur der Formel C* auf.

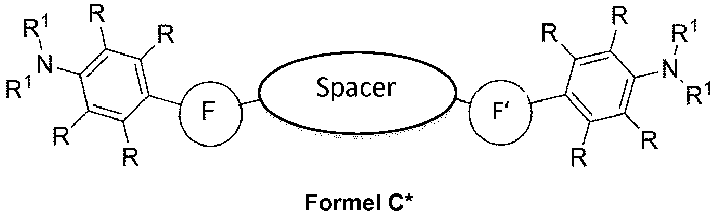

In Formel C* ist Spacer ein substituiertes oder unsubstituiertes aromatisches oder heteroaromatisches Ringsystem mit 5 bis 60 aromatischen Ringatomen und F, F' sind unabhängig von einander ein unsubstituierter oder substituierter 5- oder 6-gliederiger Ring, der optional Heteroatoma aufweist, der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 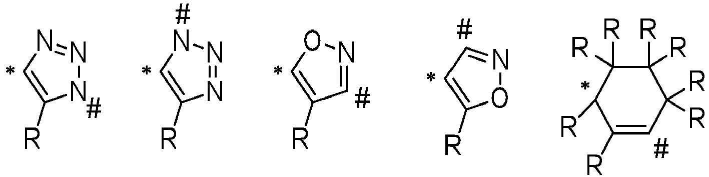 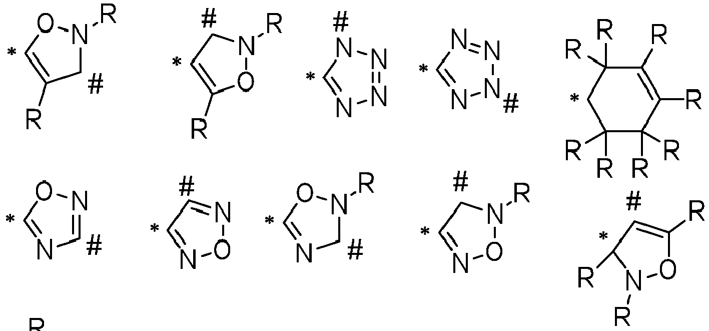 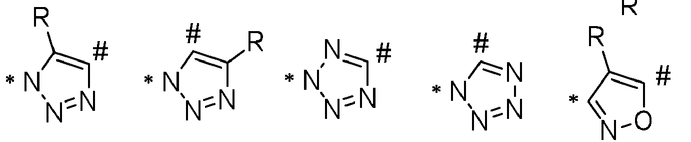 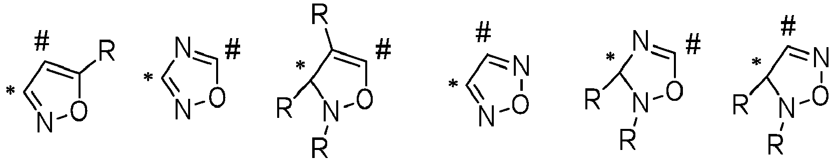 wobei
jedes R und R¹ bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(_{R}³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
und die Verknüpfung zum Spacer und zu den Phenyleinheiten an den mit * und # markierten Stellen stattfindet.

Die Erfindung betrifft in bevorzugten Ausführungsformen auch organische Moleküle aufweisend Strukturen der Formel C, C' und C* in denen R1 gleich Ar und Ar1 ist, so dass sich Strukturen der Formeln D, D' und D* ergeben..

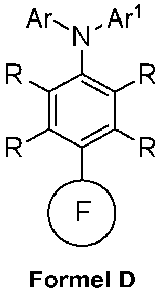

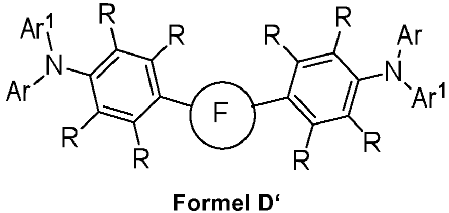

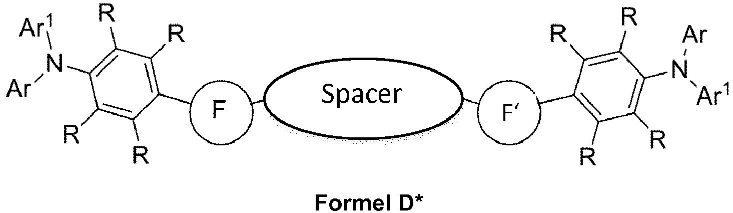

Die Einheiten F, F', R und Spacer sind wie bei den Formeln C, C' und C* entsprechend definiert.

NArAr¹ ist ein Donor, mit Ar, Ar¹ = unabhängig voneinander ein aromatisches oder heteroaromatisches Ringsystem mit 5 - 60 aromatischen Ringatomen, das jeweils durch einen oder mehrere Reste R substituiert sein kann und das über beliebige Positionen am Aromaten bzw. Heteroaromaten verknüpft sein kann. Ar und Ar¹ können auch miteinander anelliert oder über eine Einheit E miteinander verbunden sein (z. B. Carbazol, Phenoxazin, Phenothiazin); E steht für eine kovalente Einfachbindung oder für eine organische Brücke, die eine substituierte oder unsubstituierte Alkylen-, Alkenylen-, Alkinylen- oder Arylen-Gruppe oder eine Kombination dieser, oder -O-, -NR-, -C=CR₂, -C=NR, -SiR₂- -S-, -S(O)-, -S(O)₂-, durch O unterbrochene Alkyl- (unverzweigt, verzweigt oder zyklisch), Heteroalkyl-, Aryl-, Heteroaryl-, Alkenyl-Gruppen, Phenyl- und substituierte Phenyleinheiten ist.

In einer alternativen Ausführungsform steht E für eine kovalente Einfachbindung oder für eine bivalente organische Brücke ausgewählt aus der Gruppe bestehend aus substituierten und unsubstituierten Alkylen- (unverzweigt, verzweigt oder zyklisch), Alkenylen-, Alkinylen-, Arylen- und Heteroarylen-Gruppen, O, NR, C=CR₂, C=NR, SiR₂ S, S(O), S(O)₂, BR, PR, P(O)R, wobei auch Kombinationen dieser Einheiten möglich sind (z. B. durch O unterbrochene Alkylen- (unverzweigt, verzweigt oder zyklisch), Alkenylen-, Alkinylen-, Arylen- und Heteroarylen-Gruppen).

Generell ist Carbazol als Substituent bzw. davon abgeleitete Strukturen ein Schlüsselmotiv in vielen Farb- und Leuchtstoffen.^{1,2,3-6} Aus diesem Grund sind Carbazol-substituierte Verbindungen wie dem Fachmann bekannt ist gängige Verbindungen, die beispielsweise in Organischen Leuchtdioden zum Einsatz kommen.⁷⁻⁹

Mit einem von Carbazol abgeleitetem Donator D ergeben sich folgende erfindungsgemäße Strukturen der Formel E und F

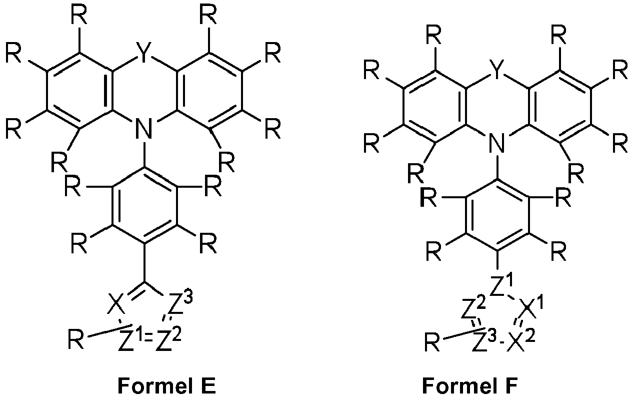

In Formel E und F sind X, X¹, X² jeweils unabhängig von einander ausgewählt aus der Gruppe bestehend aus dem Fragment CR und N. Y ist eine kovalente Einfachbindung oder ausgewählt aus der Gruppe bestehend aus, O, S, NR, CRR', C=CRR', C=NR und SiRR'. Z¹-Z³ sind jeweils unabhängig voneinander ausgewählt aus der Gruppe bestehend aus dem Fragment CRR', CR, NR, N und O, wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen X und Z¹ immer eine Einfachbindung vorhanden ist.

Jedes R und R' ist bei jedem Auftreten gleich oder verschieden H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden.

R² ist bei jedem Auftreten gleich oder verschieden H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(_{R}³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme. Zwei oder mehrere dieser Substituenten R² können dabei auch miteinander ein mono- oder polycyclisches, aliphatisches, aromatisches und/oder benzoannelliertes Ringsystem bilden.

R³ ist bei jedem Auftreten gleich oder verschieden H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können. Dabei können zwei oder mehrere Substituenten R³ auch miteinander ein mono- oder polycyclisches, aliphatisches Ringsystem bilden.

In einer Ausführungsform weist das organische Molekül eine Struktur der Formel G oder H auf, 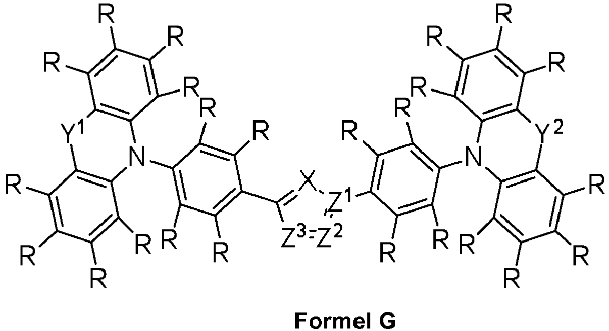 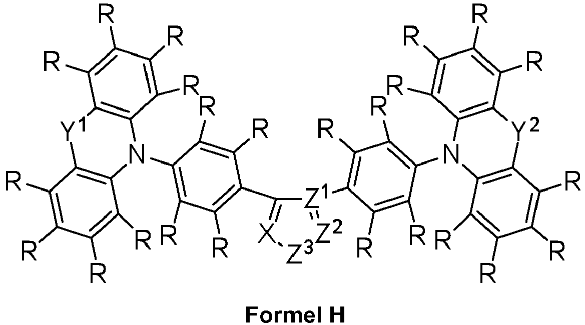 mit
X = ausgewählt aus der Gruppe bestehend aus N und dem Fragment CR;
Y¹, Y² = unabhängig voneinander ausgewählt aus der Gruppe bestehend aus einer direkten Bindung, O, S, NR, CRR', C=CRR', C=NR und SiRR';
Z¹ = ausgewählt aus der Gruppe bestehend aus C, N und dem Fragment CR;
Z² = ausgewählt aus der Gruppe bestehend aus N und dem Fragment NR;
Z³ = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X bzw. Z³ und X immer eine Einfachbindung vorhanden ist;
wobei
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(_{R}³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

Erfindungsgemäß sind auch die über einen unsubstituierten oder substituierten Phenylring als Spacer verbundenen Dimere, die eine Struktur der Formel I oder K aufweisen.

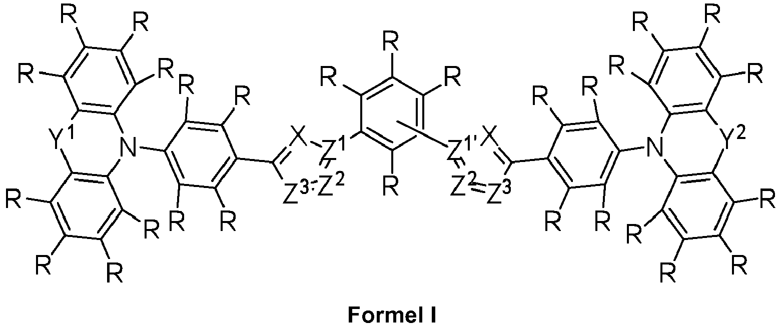

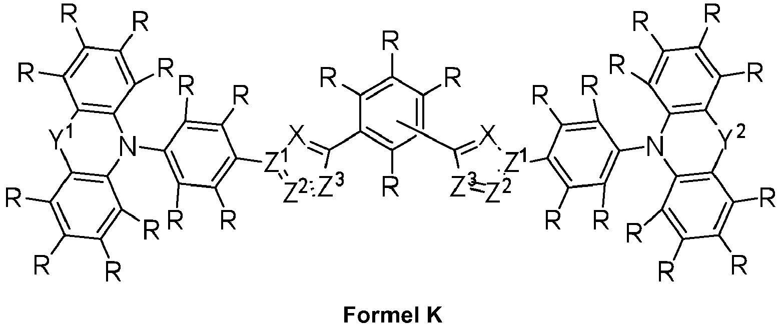

Dabei gilt:
X = ausgewählt aus der Gruppe bestehend aus N und dem Fragment CR;
Y¹, Y² = unabhängig voneinander eine kovalente Einfachbindung oder ausgewählt aus der Gruppe bestehend aus O, S, NR, CRR', C=CRR', C=NR und SiRR';
Z¹ = ausgewählt aus der Gruppe bestehend aus C, N und dem Fragment CR;
Z² = ausgewählt aus der Gruppe bestehend aus N und dem Fragment NR;
Z3 = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X immer eine Einfachbindung vorhanden ist, und die Anbindung von Z¹' an den zentralen Phenylring in ortho-, meta-, oder para-Position zu Z¹ (Formel I) sein kann bzw. die zwei 5-Ringe in ortho-, meta-, oder para-Position zueinander stehen können (Formel K), bevorzugt in meta- oder para-Position, sodass dann an diesen Positionen kein Rest R vorhanden ist, an den übrigen 4 Positionen jedoch schon;
wobei jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(_{R}³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

Zu den erfindungsgemäßen organischen Molekülen zählen auch organische Moleküle aufweisend eine Struktur der Formel A"

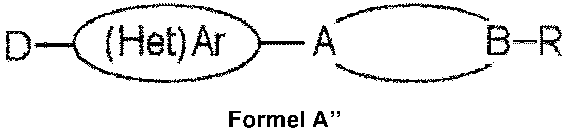

Dabei gilt
(Het)Ar = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen,
D = eine chemisch gebundene Donatorgruppe mit elektronenschiebenden Eigenschaften und
A = ein chemisch gebundenes Fragment, das aus einer Clickreaktion mit einer komplementären Einheit B ein [i+j]-Cycloadditionsprodukt ergibt.

In einer Ausführungsform der Erfindung sind A und D nicht an direkt benachbarten Atomen der konjugierten organischen Gruppe (Het)Ar gebunden.

In einer weiteren Ausführungsform ist das im Cycloadditionsprodukt auftretende Fragment B ausgewählt ist aus der Gruppe bestehend aus C, N, S, P, O und Se.

Bei den erfindungsgemäßen organischen Molekülen der Formel A" weist in einer Ausführungsform B mindestens einen Substituenten zur Erhöhung der Löslichkeit des organischen Moleküls in einem organischen Lösungsmittel auf, wobei der Substituenten zur Erhöhung der Löslichkeit bevorzugt ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
- verzweigten oder unverzweigten oder zyklischen langkettigen Perfluoralkylketten einer Länge von C1 bis C30, und
- kurzkettigen Polyethern mit einer Kettenlänge von 3 bis 50 Wiederholungseinheiten

Die Erfindung betrifft in einem Aspekt ein Verfahren zur Herstellung der erfindungsgemäßen organischen Moleküle aufweisend eine [i+j]-Cycloaddition (Clickreaktion) der mit einer Donatorgruppe D bzw. D' versehenen Het(Ar) bzw. (Het)Ar'-Gruppe, die eine zur Clickreaktion befähigte Gruppe ausgewählt aus einem Dipolarophil, 1,3-Dipol, Dienophil und Dien trägt, mit einer entsprechenden komplementären Gruppe, wobei ein unsubstituierter oder substituierter 5- oder 6-gliedriger Ring A bzw. A' ausgebildet wird.

Allgemeine Reaktionsschemata zur Cycloaddition:

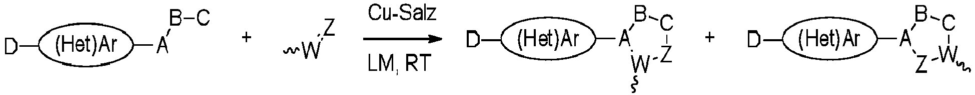

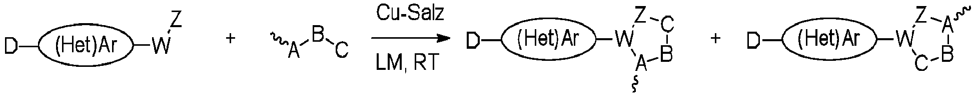

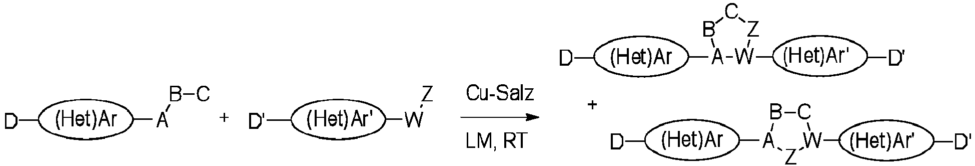

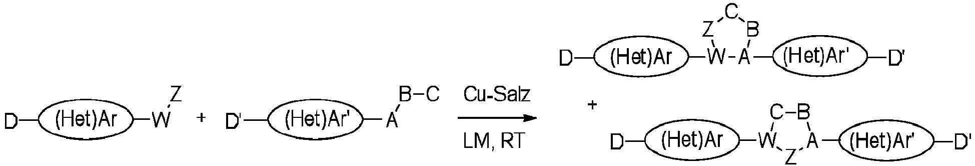

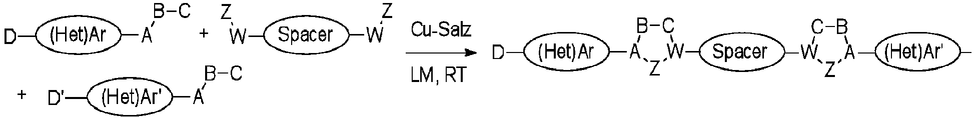

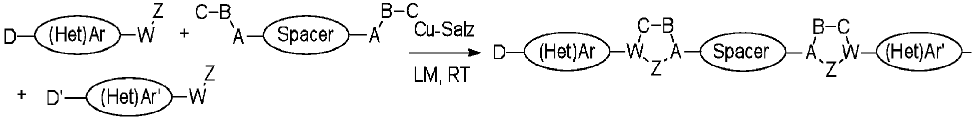

A-B-C ist dabei ein 1,3-Dipol, W-Z ein Dipolarophil, die miteinander eine dipolare Cycloaddition (Clickreaktion) eingehen, wobei ein unsubstituierter oder substituierter 5-gliedriger Ring ausgebildet wird.

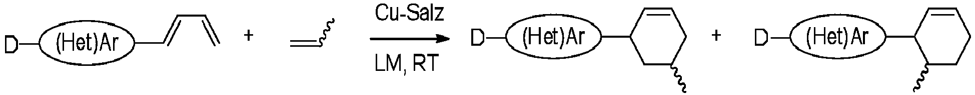

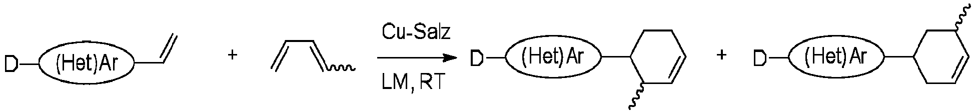

Bei den beiden letztgenannten Reaktionen handelt es sich um die Diels-Alder-Cycloaddition eines Diens mit einem Dienophil, wobei ein unsubstituierter oder substituierter 6-gliedriger Ring ausgebildet wird.

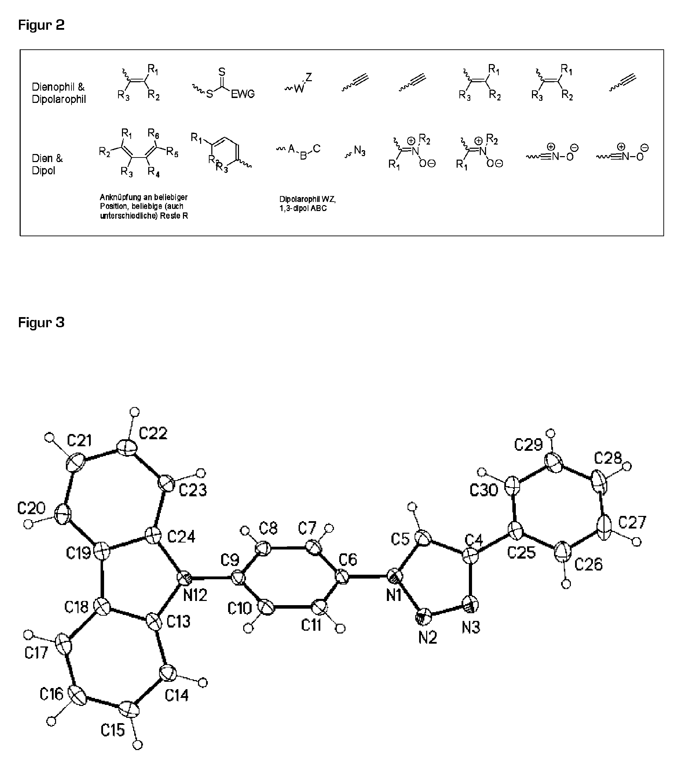

Beispiele für Dienophile und Dipolarophile und entsprechende Diene und 1,3-Dipole sind in Figur 2 angegeben.

Vorteilhaft ist die Synthese über eine Cycloaddition, da die entsprechenden Startmaterialien in der Regel gut verfügbar sind und die Cycloaddition ebenso in der Regel in guten Ausbeuten mit einem geringem Aufreinigungsaufwand durchführen lassen. Hierzu wird beispielsweise das nicht-fluoreszierende N-(4-azidophenyl)-carbazol verwendet.

Für die Cycloaddition eignet sich beispielsweise eine Kupfer-katalysierte Alkin-Azid-Click-Reaktion mit dem Katalysatorsystem Kupfer(I)-iodid in Lösungsmitteln wie Diisopropylamin. Ferner lassen sich 1,3-Dipolare Cycloadditionen unter Verwendung von cyclischen Octinen wie Cyclooctin durchführen. Triebkraft dieser Reaktion ist Reduzierung der Ringspannung, weswegen der Fachmann in diesem Zusammenhang auch von engl. *strain promoted azide alkyne cycloaddition* spricht.¹⁶ Typische Ausbeuten für derartige Umsetzungen liegen bei 74 % bis 98 %.

In einer Ausführungsform weist das Verfahren zur Herstellung der erfindungsgemäßen organischen Moleküle den Schritt der Substitution mindestens einer der Gruppen (Het)Ar, (Het)Ar', A, A', D und/oder D' mit mindestens einem Substituenten zur Erhöhung der Löslichkeit auf, der ausgewählt ist aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30 und
- kurzkettigen Polyethern mit einer Kettenlänge von 3 bis 50 Wiederholungseinheiten.

Die Erfindung betrifft auch die Verwendung eines erfindungsgemäßen organischen Moleküls als Emitter oder Absorber in einem optoelektronischen Bauelement, das insbesondere durch ein Vakuumverdampfungsverfahren oder aus Lösung hergestellt wird, wobei das optoelektronische Bauelement bevorzugt ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

Der Anteil des erfindungsgemäßen organischen Moleküls am Emitter oder Absorber beträgt in einer Ausführungsform 1 % bis 99 %, bevorzugt beträgt der Anteil am Emitter in optischen Licht emittierenden Bauelementen, insbesondere in OLEDs, zwischen 5 und 80 %. In einer alternativen Ausführungsform beträgt der Anteil des organischen Moleküls am Emitter oder Absorber 100 %.

Erfindungsgemäß sind auch entsprechende optoelektronische Bauelemente, aufweisend ein erfindungsgemäßes organisches Molekül, wobei das optoelektronische Bauelement insbesondere ausgeformt ist als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

In einer Ausführungsform des erfindungsgemäßen Bauelements wird das organische Molekül als Emissionsmaterial in einer Emissionsschicht eingesetzt wird, wobei sie in Kombination mit einem Matrixmaterial oder insbesondere als Reinschicht oder eingesetzt werden kann.

In einer weiteren Ausführungsform beträgt der Anteil des organischen Moleküls als Emissionsmaterial in einer Emissionsschicht in optischen Licht emittierenden Bauelementen, insbesondere in OLEDs, zwischen 5 % und 80 %.

In einer weiteren Ausführungsform des erfindungsgemäßen Bauelements ist die ein erfindungsgemäßes organisches Molekül aufweisende lichtemittierende Schicht auf ein Substrat aufgebracht.

Erfindungsgemäß ist auch ein optoelektronisches Bauelement, aufweisend ein erfindungsgemäßes organisches Molekül, welches ein Substrat, eine Anode und eine Kathode aufweist, wobei die Anode und die Kathode auf das Substrat aufgebracht ist, und die lichtemittierende Schicht zwischen Anode und Kathode aufgebracht ist.

In einer Ausführungsform betrifft die Erfindung ein optoelektronisches Bauelement, wobei die lichtemittierende Schicht ausschließlich ein erfindungsgemäßes organisches Molekül in 100 % Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das erfindungsgemäße optoelektronische Bauelement neben dem erfindungsgemäßen organischen Molekül auch ein Hostmaterial auf, dessen Triplett (T1)- und Singulett (S1)-Energieniveaus energetisch höher liegen als die Triplett (T1)- und Singulett (S1)-Energieniveaus des organischen Moleküls, wobei die Anode und die Kathode auf das Substrat aufgebracht ist, und die lichtemittierende Schicht zwischen Anode und Kathode aufgebracht ist.

In einer weiteren Ausführungsform weist das erfindungsgemäße optoelektronische Bauelement ein Substrat, eine Anode, eine Kathode und mindestens je eine löcher- und elektroneninjizierende Schicht und mindestens eine lichtemittierende Schicht auf, wobei die mindestens eine lichtemittierende Schicht ein erfindungsgemäßes organisches Molekül und ein Hostmaterial aufweist, dessen Triplett (T1)- und Singulett (S1)-Energieniveaus energetisch höher liegen als die Triplett (T1)- und Singulett (S1)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer Ausführungsform weist das erfindungsgemäße optoelektronische Bauelement ein Substrat, eine Anode, eine Kathode und mindestens je eine löcher- und eine elektroneninjizierende Schicht, und mindestens je eine löcher- und eine elektronentransportierende Schicht, und mindestens eine lichtemittierende Schicht auf, wobei die mindestens eine lichtemittierende Schicht ein erfindungsgemäßes organisches Molekül sowie ein Hostmaterial aufweist, dessen Triplett (T1)- und Singulett (S1)-Energieniveaus energetisch höher liegen als die Triplett (T1)- und Singulett (S1)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

Die Erfindung betrifft in einer Ausführungsform auch ein lichtemittierendes Material, aufweisend ein erfindungsgemäßes organisches Molekül und ein Hostmaterial, wobei die Triplett (T1)- und Singulett (S1)-Energieniveaus des Hostmaterials energetisch höher liegen als die Triplett (T1)- und Singulett (S1)-Energieniveaus des organischen Moleküls, und wobei das organische Molekül Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 3000 cm⁻¹ aufweist.

Erfindungsgemäß ist auch ein Verfahren zur Herstellung eines optoelektronischen Bauelements aufweisend ein erfindungsgemäßes organisches Molekül.

In einer bevorzugten Ausführungsform ist das Verfahren gekennzeichnet durch das Aufbringen des organischen Moleküls auf einen Träger, wobei das Aufbringen bevorzugt nass-chemisch, mittels kolloidaler Suspension oder mittels Sublimation erfolgt.

In einer weiteren bevorzugten Ausführungsform ist das Verfahren dadurch gekennzeichnet, dass mindestens eine Schicht
- mit einem Sublimationsverfahren beschichtet wird
- mit einem OVPD (Organic Vapour Phase Deposition) Verfahren beschichtet wird
- mit Hilfe einer Trägergassublimation beschichtet wird oder
- aus Lösung oder mit einem beliebigen Druckverfahren hergestellt wird.

Erfindungsgemäß ist darüber hinaus auch ein Verfahren zur Veränderung der Emissions- und/oder Absorptionseigenschaften eines elektronischen Bauelements eine erfindungsgemäßes organisches Molekül in ein Matrixmaterial zur Leitung von Elektronen oder Löchern in einem optoelektronischen Bauelement eingebracht wird.

Die Erfindung betrifft zudem in einem weiteren Aspekt die Verwendung eines erfindungsgemäßen Moleküls zur Umwandlung von UV-Strahlung oder von blauem Licht in sichtbares Licht, insbesondere in grünes, gelbes oder rotes Licht (down-Konversion), insbesondere in einem optoelektronischen Bauelement.

Die Anknüpfung von D bzw. D' und A bzw. A' an die Einheit (Het)Ar bzw. (Het)Ar' führt dazu, dass sich diese Gruppen zueinander verdrehen müssen und somit nicht parallel und damit in Konjugation zueinander stehen, wodurch diese elektronisch entkoppelt werden. In einer Ausführungsform führt die Anknüpfung von D bzw. D' und A bzw. A' an die Einheit (Het)Ar bzw. (Het)Ar' dazu, dass sich diese Gruppen zueinander verdrehen müssen und somit orthogonal zueinander stehen. Diese Entkopplung kann beispielsweise durch quantenmechanische Berechnungen des HOMO und LUMO nachvollzogen werden. Diese beiden Grenzorbitale sollten demnach keine bzw. eine möglichst geringe Überlappung zeigen. Das pi-System der zentralen Grundeinheit kann dabei hauptsächlich entweder Teil des HOMO oder des LUMO sein.

Zur räumlichen Trennung der Orbitale HOMO und LUMO sind die aromatischen und heteroaromatischen Ringsysteme der erfindungsgemäßen Moleküle gegeneinander verdrillt. Durch diese Verdrillung ist die Konjugation der pi-Systeme gebrochen, wodurch HOMO und LUMO auf unterschiedlichen Molekülteilen lokalisiert und nicht über das gesamte Molekül delokalisiert vorliegen. Diese Verdrillung kann beispielsweise durch Röntgenkristallografie nachgewiesen werden (siehe auch Figur 2).

Die Ergebnisse von UVVIS-Messungen in Lösung (siehe auch Tabelle 1) legen nahe, dass die gewünschte Verdrillung der pi-Systeme nicht nur in Kristallen, sondern auch in Lösung und im amorphen Festkörper auftritt. Die Absorptionsspektren stellen somit die Superposition der Absorptionsspektren der isolierten pi-Systeme dar. Weitere breite, unstruktierte Banden zwischen 300 und 350 nm mit geringen Absorptionskoeffizienten treten aufgrund von Charge-Transfer-Übergängen auf, die zur Emission von sichtbarem Licht führen. Außerdem finden sich in der Tabelle Daten zur Emissionsfarbe der Verbindungen, die bei den gezeigten Beispielen im blauen Spektralbereich liegt.

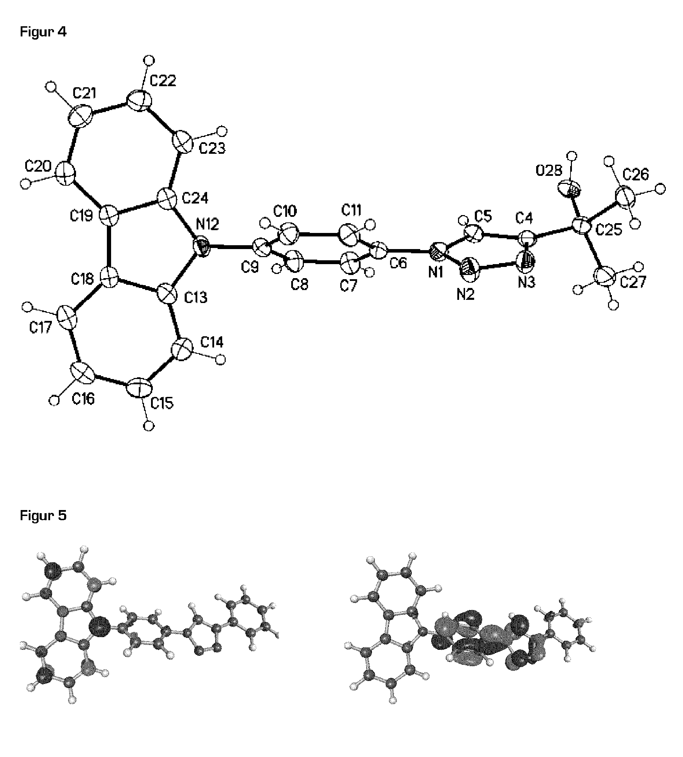

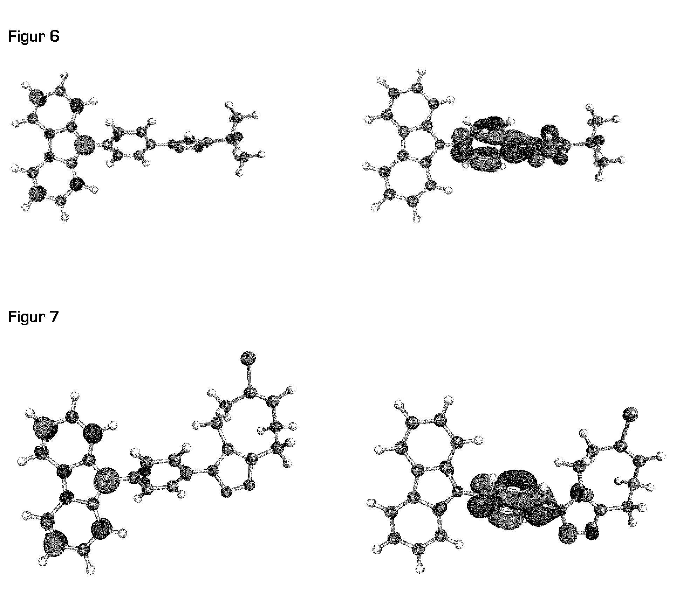

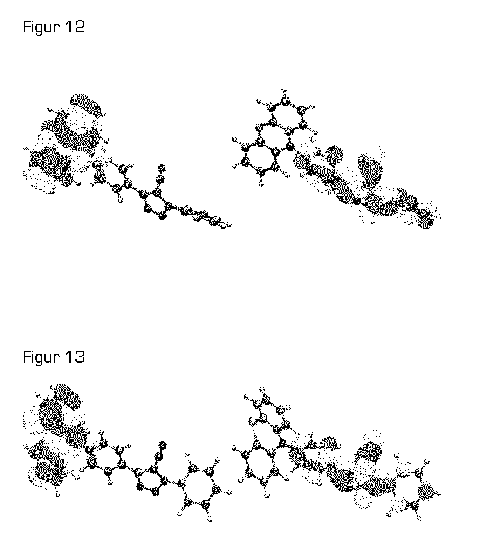

Durch quantenchemische Rechnungen (DFT, B3-LYP/def2-TZVP Level)¹⁸ konnten die Grenzorbitale visualisiert werden, wie in Figur 5 bis 13 dargestellt ist. Wie gewünscht liegt das HOMO auf der elektronenspendenen Donorgruppe, während das LUMO auf der elektronenziehenden Akzeptorgruppe liegt. Die Emission der erfindungsgemäßen Verbindungen beruht demnach auf der Verdrillung zwischen Donor und Akzeptor, wodurch ein geringer ΔE_{ST}-Wert hervorgerufen wird.

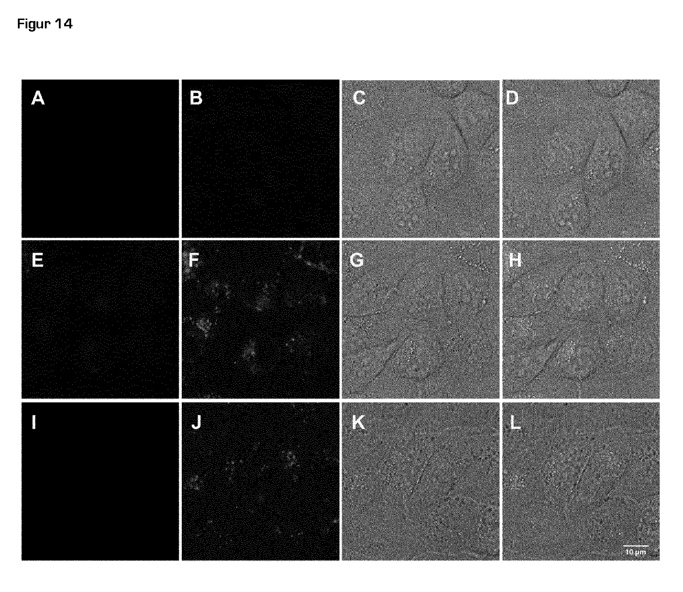

Aufgrund der besonders vorteilhaften Eigenschaften lassen sich die erfindungsgemäßen Verbindungen auch in der Biologie oder Medizin, insbesondere in einem Verfahren zur Markierung von Zellen, beispielsweise als Lumineszenzmarker einsetzen. Die Eignung für diese Anwendung wurde durch Konvokalmikroskopie nachgewiesen. Hierzu wurden HeLa-Zellen mit den Molekülen 2 und 7 markiert und mittels Laser zur Lumineszenz angeregt. Wie in Figur 14 gezeigt ist, wurden die Leuchtstoffe im endosomal-lysosomalen System bevorzugt aufgenommen.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroaryl-gruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluor-methyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C1 bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spiro-bifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroiso-truxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazin-imidazol, Chinoxalinimidazol, Oxazol, Benzoxazol, Naphthoxazol, Anthroxazol, Phenanthroxazol, Isoxazol, 1,2-Thiazol, 1,3-Thiazol, Benzo-thiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Aza-carbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thia-diazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

### Referenzen

1. Y. F. Lan and J. J. Lin, Dyes Pigments, 2011, 90, 21-27.
2. R. Levinson, P. Berdahl and H. Akbari, Sol Energ Mat Sol C, 2005, 89, 351-389.
3. W. Maes, T. H. Ngo, G. Rong, A. S. Starukhin, M. M. Kruk and W. Dehaen, Eur J Org Chem, 2010, 2576-2586.
4. M. Tavasli, T. N. Moore, Y. H. Zheng, M. R. Bryce, M. A. Fox, G. C. Griffiths, V. Jankus, H. A. Al-Attar and A. P. Monkman, J Mater Chem, 2012, 22, 6419-6428.
5. A. C. Grimsdale, K. L. Chan, R. E. Martin, P. G. Jokisz and A. B. Holmes, Chem Rev, 2009, 109, 897-1091.
6. G. Moad, M. Chen, M. Haussler, A. Postma, E. Rizzardo and S. H. Thang, Polym Chem-Uk, 2011, 2, 492-519.
7. S. Y. Takizawa, V. A. Montes and P. Anzenbacher, Chem Mater, 2009, 21, 2452-2458.
8. Y. Heischkel and H. W. Schmidt, Macromol Chem Physic, 1998, 199, 869-880.
9. D. Volz, T. Baumann, H. Flugge, M. Mydlak, T. Grab, M. Bachle, C. Barner-Kowollik and S. Brase, J Mater Chem, 2012, 22, 20786-20790.
10. V. V. Rostovtsev, L. G. Green, V. V. Fokin and K. B. Sharpless, Angew. Chem., 2002, 41, 2596-2599.
11. C. W. Tornoe, C. Christensen and M. Meldal, J. Org. Chem., 2002, 67, 3057-3064.
12. H. Jang, A. Fafarman, J. M. Holub and K. Kirshenbaum, Org. Lett., 2005, 7, 1951-1954.
13. R. N. Zuckermann, J. M. Kerr, S. B. H. Kent and W. H. Moos, J. Am. Chem. Soc., 1992, 114, 10646-10647.
14. D. K. Kölmel, D. Fürniss, S. Susanto, A. Lauer, C. Grabher, S. Bräse and U. Schepers, Pharmaceuticals (Basel), 2012, 5, 1265-1281.
15. T. Schröder, K. Schmitz, N. Niemeier, T. S. Balaban, H. F. Krug, U. Schepers and S. Bräse, Bioconj. Chem., 2007, 18, 342-354.
16. N. J. Agard, J. A. Prescher and C. R. Bertozzi, J. Am. Chem. Soc., 2004, 126, 15046-15047.
17. G. M. Sheldrick, Acta Crystallographica Section A, 2008, 64, 112-122.
18. S. Fery-Forgues and D. Lavabre, J. Chem. Educ., 1999, 76, 1260-1264.
19. C. T. Lee, W. T. Yang and R. G. Parr, Phys. Rev. B, 1988, 37, 785-789.
20. F. Weigend and R. Ahlrichs, Phys. Chem. Chem. Phys., 2005, 7, 3297-3305.
21. S. Grimme, J. Antony, S. Ehrlich and H. Krieg, J. Chem. Phys., 2010, 132**.**
22. A. Klamt and G. Schüürmann, Perkin Trans. 2, 1993, 799-805.

### Beispiele

### Synthese von N-(4-Azidophenyl)carbazol 1

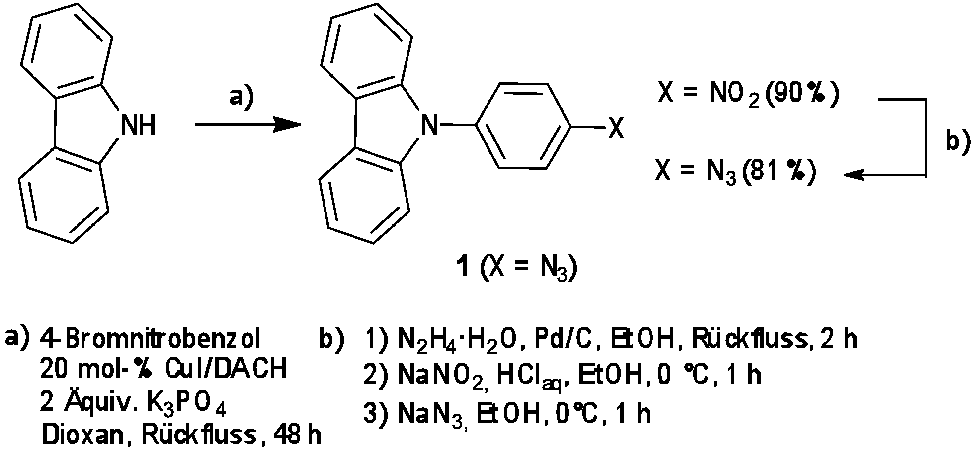

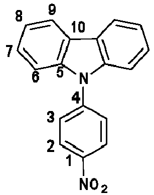

*9-(4-Nitrophenyl)-9H-carbazol:* Die Synthese erfolgte nach einer modifizierten Literaturvorschrift für 100 mmol Carbazol.¹⁰ K₂CO₃ wurde durch K₃PO₄ ersetzt und Dioxan anstatt DMF als Lösungsmittel verwendet. Rekristallisation aus CHCl₃ ergab 9-(4-Nitrophenyl)-9H-carbazol in 90%iger Ausbeute als gelben Feststoff. (26,0 g, 90,0 mmol, 90%) - ¹H-NMR (400 MHz, CDCl₃): δ = 8,39 (d, *J* = 8,2, 2 H, CHCNO₂), 7,90-8,10 (m, 4 H, Ar-H), 7,63 (d, *J* = 8,2, 2 H, CHCCbz), 7,10-7,50 (m, 4 H, Ar-H) ppm. - ¹³C-NMR (125 MHz, CDCl₃): δ = 144,70 (C_{quart}, C-1), 142,74 (C_{quart}, C-4), 138,41 (C_{quart}, 2 C, C-5), 125,61 (+, 2 C, C-3), 125,12 (+, 2 C, C-3), 124,45 (+, 2 C, C-2), 123,73 (C_{quart}, 2 C, C-10), 120,24 (+, 2 C, C-9), 119,58 (+, 2 C, C-8), 109,52 (+, 2 C, C-6) ppm.-IR (ATR): v = 3416 (vw), 3049 (vw), 2923 (vw), 1892 (vw), 1702 (vw), 1594 (s), 1502 (vs), 1480 (s), 1450 (s), 1365 (w), 1342 (vs), 1316 (vs), 1227 (vs), 1177 (m), 1121 (w), 1101 (s), 1003 (w), 915 (m), 840 (vs), 741 (vs), 718 (vs), 689 (vs), 637 (m), 617 (m), 410 (s) cm⁻¹. - MS (70 eV, EI), *m*/*z* (%): 292 (2) [M] ⁺, 248 (1) [M-NO₂] ⁺, 219 (1), 167 (100) [M-NO₂-Ph] ⁺, 139 (10), 77 (73), 50 (48). - HR-EIMS (C₁₈H₁₂N₂O₂): ber. 288,0898; gef. 288,0896. 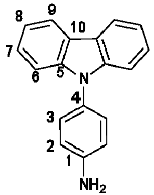 *9-(4-Aminophenyl)-9H-carbazol:* Verfahren nach einer modifizierten Literaturvorschrift.¹¹ Zu einer unter Rückfluss erhitzten Lösung von 9-(4-Nitrophenyl)-9*H*-carbazol (8,36 g, 29,0 mmol) und Pd/C (463 mg) in Ethanol (100 mL) wurde tropfenweise Hydrazinemonohydrat (10,0 mL) hinzugefügt. Die Mischung wure für 4 h unter Rückfluss erhitzt und auf Raumtemperatur abgekühlt. Pd/C wurde durch Filtration durch basisches Aluminiumoxid entfernt und das Filtrat wurde konzentriert und ergab 9-(4-Aminophenyl)-9H-carbazol als klare viskose Flüssigkeit (7,50 g, 29,0 mmol) in 99%iger Ausbeute. Das Produkt wurde ohne weitere Aufreinigung direkt in den nächsten Schritt eingesetzt. - ¹H-NMR (300 MHz, DMSO-d6): 5 = 8,19 (d, *J* = 8,1 Hz, Ar-H, 2H); 7,40 (t, ³*J_{H-H} =* 7,5 Hz, Ar-H, 2 H), 7,27-7,21 (m, Ar-H, 4 H), 7,18 (d, ³*J_{H}-_{H}*= 9,0 Hz, Ar-H, 2 H), 6,81 (d, , ³*J_{H-H} =* 8,4 Hz, Ar-H, 2 H), 5,35 (s, NH₂, 2 H) ppm.

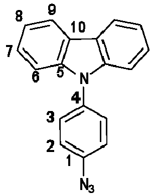

*9-(4-Azidophenyl)-9H-carbazol* **1:** Eine gerührte Suspension von 9-(4-Aminophenyl)-9H-carbazol (9,04 g, 35,0 mmol, 1,00 Äquiv.) in einer Mischung aus 100 mL Wasser und 7 mL konzentrierter Salzsäure wurde auf 0 °C abgekühlt. Eine Lösung von Natriumnitrit (2,66 g, 38,5 mmol, 1,10Äquiv.) in 38 mL Wasser wurde tropfenweise hinzugefügt. Währenddessen änderte sich die Farbe des Niederschlages von weiß zu rot, anzeigend die Bildung eines Diazoniumsalzes. Nach 15 Minuten bei 0 °C wurde langsam eine Lösung von Natriumazid (2,73 g, 42,0 mmol, 1,20 Äquiv.) in 38 mL Wasser hinzugefügt. Der Beginn des zweiten Reaktionsschrittes wird angezeigt durch eine starke Stickstoffbildung, was zum Schäumen führte. Daher ist ein Reaktionskolben einer angemessenen Größe (500 mL oder größer) aus Sicherheitsgründen empfohlen. Nach der kompletten Zugabe wurde das Eisbad entfernt und die Reaktionsmischung für 30 Minuten gerührt. Das Rohprodukt wurde durch Filtration der Reaktionsmischung, gefolgt von Waschen mit Wasser (500 mL) und Methanol (30 mL) erhalten und weiter aufgereinigt durch Flash-Chromatographie an Kieselgel und Cyclohexan/Ethylacetat /10:1) als Eluent. Die Verbindung 1 wurde nach Trocknung in 81 %iger Aubeute als gelblicher Feststoff isoliert und bei 4 °C in einem dunklen Kolben gelagert um die Zersetzung des Azids zu vermeiden. (8,10 g, 28,5 mmol) - R_{f} = 0,24 - ¹H-NMR (400 MHz, CDCl₃): δ = 8,06 (dt, , 3*J_{H-H}* = 7,8, 1,0 Hz, 2H, Ar-H), 7,53-7,40 (m, 2H, Ar-H), 7,40-7,10 (m, 8H, Ar-H) ppm. - ¹³C-NMR (125 MHz, CDCl₃): δ = 140,90 (+, 2 C, C-2), 139,20 (C_{quart}, C-4), 134,44 (C_{quart}, 2 C, C-5), 128,63 (+, 2 C, C-3), 126,96 (C_{quart}, C-1), 125,84 (+, 2 C, C-2), 123,59 (C_{quart}, 2 C, C-10), 120,35 (+, 2 C, C-9), 120,09 (+, 2 C, C-8), 109,68 (+, 2 C, C-6) ppm. - IR (DRIFT): v = 3416 (vw), 3052 (vw), 2412 (vw), 2254 (vw), 2115 (vs), 2115 (vs), 1596 (m), 1507 (w), 1478 (vs), 1450 (s), 1364 (vs), 1336 (w), 1319 (w), 1289 (w), 1275 (s), 1230 (s), 1182 (s), 1148 (s), 1128 (m), 1110 (m), 1014 (m), 998 (w), 932 (w), 912 (w), 855 (w), 832 (w), 812 (w), 777 (w), 752 (vs), 725 (vs), 665 (m), 641 (m), 621 (m), 570 (m), 531 (m), 510 (m), 448 (m), 425 (m) cm⁻¹. - MS (70 eV, EI), *m*/*z* (%): 284 (70) [M]⁺, 256 (100) [M-N₂] ⁺, 229 (13), 167 (50) [Cbz] ⁺, 153 (29), 136 (18), 105 (50) 77 (56), 55 (39). - HR-EIMS (C₁₈H₁₂N₄): ber. 284,1062; gef. 284,1063. - Elementaranalyse für C₁₈H₁₂N₄: ber. C 76,04, H 4,25, N 19,71; gef. C 76,33, H 4,37, N 19,33.

### Reaktion von N-4-Azidophenyl)carbazol 1 mit terminalen Alkinen

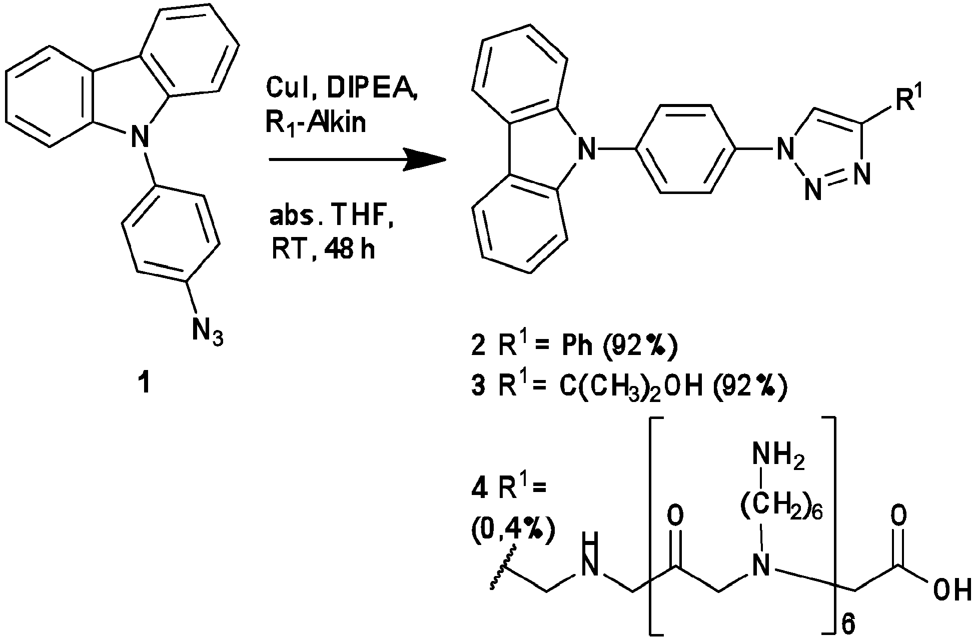

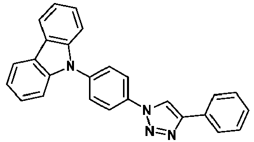

*9-(4-(4-Phenyl-1H-1,2,3-triazol-1-yl)phenyl)-9H-carbazol* 2: In einem geschlossenen Reaktionsgefäß wurden 142 mg Azidocarbazol 1 (0,500 mmol, 1,00 equiv.), 51 mg Phenylacetylen (0,500 mmol, 1,00 Äquiv.), 143 mg Kupferiodid (0,750 mmol, 1,50 Äquiv.) in 4,35 mL DIPEA (25,0 mmol, 50,0 Äquiv.) und 6,00 mL trockenem THF gelöst. Die Mischung wurde für 48 h bei Raumtemperatur gerührt. Danach wurde das Lösungsmittel entfernt und das Rohprodukt wurde durch Flash-Chromatographie an Kieselgel mit Cyclohexan/Ehtylacetat (8:1) als Eluent aufgereinigt. Erneute Aufreinigung mittels einer HPLC ergab die Verbindung 2 als farblose Kristalle in 92 %iger Ausbeute. (28 mg, 0,073 mmol) - mp: 205,5 °C - ¹H-NMR (400 MHz, CDCl₃): δ = 8,30 (s, 1 H, C*H*N), 8,20-8,15 (m, 2 H, Ar-H), 8,08-8,03 (m, 2 H, Ar-H), 8,00-7,94 (m, 2 H, Ar-H), 7,81-7,76 (m, 2 H, Ar-H), 7,53-7,44 (m, 6 H, Ar-H), 7,44-7,38 (m, 1 H, Ar-H), 7,38-7,31 (m, 2 H, Ar-H) ppm. - ¹³C-NMR (100 MHz, CDCl₃): δ = 148,7 (C_{quart}, C_{quart}CHN), 140,5 (C_{quart}, 2 C, C_{quart}C_{quart}N), 138,2 (C_{quart}, C_{quart}N), 135,7 (C_{quart}, C_{quart}N), 130,0 (C_{quart}, C_{quart}C_{quart}CH), 129,0 (+, 2 C, C_{Ar}), 128,6 (+, C_{Ar}), 128,3 (+, 2 C, C_{Ar}), 126,2 (+, 2 C, C_{Ar}), 125,9 (+, 2 C, C_{Ar}), 123,6 (C_{quart}, 2 C, C_{quart}C_{quart}N), 122,0 (+, 2 C, C_{Ar}), 120,5 (+, 2 C, C_{Ar}), 120,4 (+, 2 C, C_{Ar}), 117,5 (+, C_{Ar}), 109,5 (+, 2 C, C_{Ar}) ppm. - IR (ATR): v = 2921 (vw), 1677 (w), 1606 (w), 1523 (m), 1478 (w), 1450 (m), 1415 (w), 1366 (w), 1332 (w), 1318 (w), 1224 (m), 1181 (w), 1148 (w), 1113 (w), 1071 (w), 1035 (w), 1025 (w), 991 (w), 908 (w), 844 (w), 828 (w), 792 (w), 776 (vw), 747 (m), 722 (m), 687 (m), 638 (w), 619 (w), 567 (w), 542 (w), 502 (w), 465 (w), 424 (w) cm⁻¹. - MS (70 eV, EI), m/z (%): 386,2 (16) [M] ⁺, 358,2 (100) [M-N₂]⁺, 241,1 (23). - HR-EIMS (C₂₆H₁₈N₄): ber. 386,1531; gef. 386,1530.

Die Röntgenstruktur von 2 ist in Figur 3 angegeben.

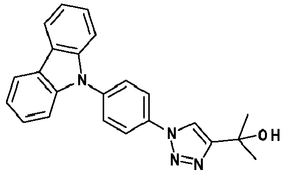

*2-(1-(4-(9H-Carbazol-9-yl)phenyl)-1H-1,2,3-triazol-4-yl)propan-2-ol* 3: In einem geschlossenen Reaktionsgefäß wurden 142 mg Azidocarbazol 1 (0,500 mmol, 1,00 equiv.), 42 mg 2-Methyl-3-butin-2-ol (0,500 mmol, 1.00 Äquiv.), 143 mg Kupferiodid (0,750 mmol, 1,50 Äquiv.) in 4,35 mL DIPEA (25,0 mmol, 50,0 Äquiv.) und 6,00 mL trockenem THF gelöst. Die Mischung wurde für 48 h bei Raumtemperatur gerührt. Danach wurde das Lösungsmittel entfernt und das Rohprodukt wurde durch Flash-Chromatographie an Kieselgel mit Cyclohexan/Ehtylacetat (2:1) als Eluent aufgereinigt. Erneute Aufreinigung mittels einer HPLC ergab die Verbindung 3 als ockerfarbene Kristalle in 92 %iger Ausbeute. (169 mg, 0,459 mmol). - mp: 155,1 °C-¹H-NMR (400 MHz, CDCl₃): δ = 8,18 - 8,14 (m, 2 H, Ar-H), 8,02 - 7,96 (m, 3 H, Ar-H), 7,78 - 7,74 (m, 2 H, Ar-H), 7,46 - 7,42 (m, 4 H, Ar-H), 7,36 - 7,30 (m, 2 H, Ar-H), 1,76 (s, 6 H, CH₃) ppm. - ¹³C-NMR (100 MHz, CDCl₃): δ = 156,6 (C_{quart}, C_{quart}CHN), 140,5 (C_{quart}, 2 C, C_{quart}C_{quart}N), 138,1 (C_{quart}, C_{quart}N), 135,7 (C_{quart}, C_{quart}N), 128,3 (+, 2 C, C_{Ar}), 126,2 (+, 2 C, C_{Ar}), 123,6 (C_{quart}, 2 C, C_{quart}C_{quart}N), 122,1 (+, 2 C, C_{Ar}), 120,5 (+, 2 C, C_{Ar}), 120,4 (+, 2 C, C_{Ar}), 117,6 (+, C_{Ar}), 109,5 (+, 2 C, C_{Ar}), 68,8 (C_{quart}, C_{quart}OH), 30,5 (+, 2 C, CH₃) ppm. - IR (ATR): v = 3269 (w), 2972 (w), 1625 (w), 1599 (w), 1518 (m), 1478 (m), 1451 (m), 1361 (m), 1334 (w), 1315 (m), 1233 (m), 1204 (w), 1174 (m), 1146 (m), 1117 (w), 1102 (w), 1047 (m), 990 (w), 962 (m), 930 (w), 917 (w), 859 (w), 837 (m), 804 (m), 747 (s), 723 (s), 670 (w), 622 (m), 562 (w), 542 (m), 456 (w), 428 (w) cm⁻¹. - MS (70 eV, EI), *m*/*z* (%): 368,1 (44) [M] ⁺, 350,1 (18) [M-H₂O] ⁺, 340,1 (10) [M-N₂]⁺, 282,1 (26), 241,0 (52), 43,0 (100) [C₃H₇]⁺. - HR-EIMS (C₂₃H₂₀N₄O): ber. 368,1637; gef. 368,1634.

Die Röntgenstruktur von 3 ist in Figur 4 angegeben. 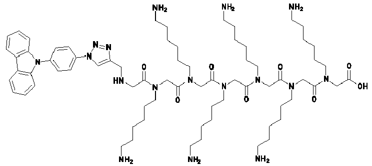 *Carbazolpeptoid* 4: Zur Synthese wurden 77,0 mg (0,100 mmol, 1,00 Äquiv.) 2-Chlorotritylchloridresin in einer gefritteten Plastikspritze (Multisyntech) mit 1 mL Dichlormethan für 30 Minuten aufgequollen. Das erste Submonomer wurde hinzugefügt durch Reaktion von 75,0 mg Bromessigsäure (0,540 mmol, 5,40 Äquiv.) und 97 *µ*L DIPEA (70,0 mg, 0,540 mmol, 5,40 Äquiv.) in 1 mL Dichloromethan auf einer Rüttelplatte für 40 Minuten bei Raumtemperatur, gefolgt von Waschen mit Dichloromethan (2 mL) und *N*,*N*-Dimethylacetamid (DMA, fünfmal mit 2 mL). Das bromoacetylierte Harz wurde mit 2 M *tert-*butyl(6-aminohexyl)carbamatlösung (0.400 mL, 0.800 mmol, 8.00 equiv.) in DMA auf einer Rüttelplatte bei Raumtemperatur inkubiert, gefolgt von Waschen mit DMA (dreimal 2 mL). Die Reaktionszeit für den Austausch betrug 30 Minuten für *tert*-Butyl(6-aminohexyl)carbamat. Die folgenden Bromoacetylierungen wurde durch 30 minütige Reaktion des Resins mit 1.2 M Bromoessigsäurelösung (0,660 mL, 1,03 mmol, 7,92 Äquiv.) in DMA und 122 µL DIC (100 mg, 0,790 mmol, 7,90 equiv.) ausgeführt. Kupplungsschritte wurden fortgeführt, bis dass die gewünschte Peptoidlänge erzielt war. Für die letzte Austauschreaktion wurde das Resin mit 2 M Propargylaminlösung (0.,400 mL, 0,800 mmol, 8,00 Äquiv.) in DMA auf einer Rüttelplatte bei Raumtemperatur für 30 Minuten inkubiert. Nach dem letzten Schritt wurde das Resin mit DMA (viermal mit 2 mL) und mit Dichlormethan (zweimal mit 1,5 mL) gewaschen. Einige Beads wurden vom Resin für eine Testspaltung entnommen und mit Trifluoroessigsäure (TFA) in einem Eppendorfröhrchen bedeckt. - MS (MALDI-TOF, C₅₃H₁₀₃N₁₃O₈): ber.: 1049,8 g/mol; gef.: 1050,8 [(M+H)] +

Für die Reaktion mit dem Azidocarbazol 1 wurde das Resin in trockenem THF aufgequollen und 23 mg Cu(CH₃CN)₄PF₆ (61,0 µmol, 0,610 Äquiv.) wurde direkt in die das Harz enthaltende Plastikspritze eingewogen. In 2 mL trockenem THF wurden 34 mg des Azidocarbazols 1 (0,120 mmol, 1,20 Äquiv.) und 33 µL 2,6-Lutidine (30,0 mg, 0,278 mmol, 2,78 Äquiv.) gelöst und zu dem Resin hinzugefügt. Das Resin wurde für 18 h bei Raumtemperatur geschüttelt.

Nach der Reaktion wurde das Harz mit *N*,*N*-Dimethylacetamid (DMA) and Dichloromethan (DCM) gewaschen (dreimal mit je 2 mL).

Das Peptoid wurde vom Harz abgespalten durch Verwendung von 2,00 mL 50% Trifluoroessigsäure (TFA) in Dichloromethan (v/v) für 18 h bei Raumtemperatur. Nach Sammeln der Abspaltungslösung wurde das Harz mit Methanol gewaschen (fünfmal mit 3 mL). Die Elutions- und die Waschlösungen wurden zusammengegeben. Das Lösungsmittel wurde unter vermindertem Druck entfernt, gefolgt von HPLC Aufreinigung des Rohproduktes und nachfolgender Lyophilisierung. Nach Abspaltung, HPLC Aufreinigung und Lyophilisierung wurde die Verbindung **4** als weißer Feststoff in 0,4 %iger Ausbeute erhalten. (0,5 mg, 0,370 µmol)-MS (MALDI-TOF, C₇₁H₁₁₅N₁₇O₈): ber.: 1333,9; gef.: 1334,9 [(M+H)]⁺.

### Reaktion von N-4-Azidophenyl)carbazol 1 mit Cyclooctinen

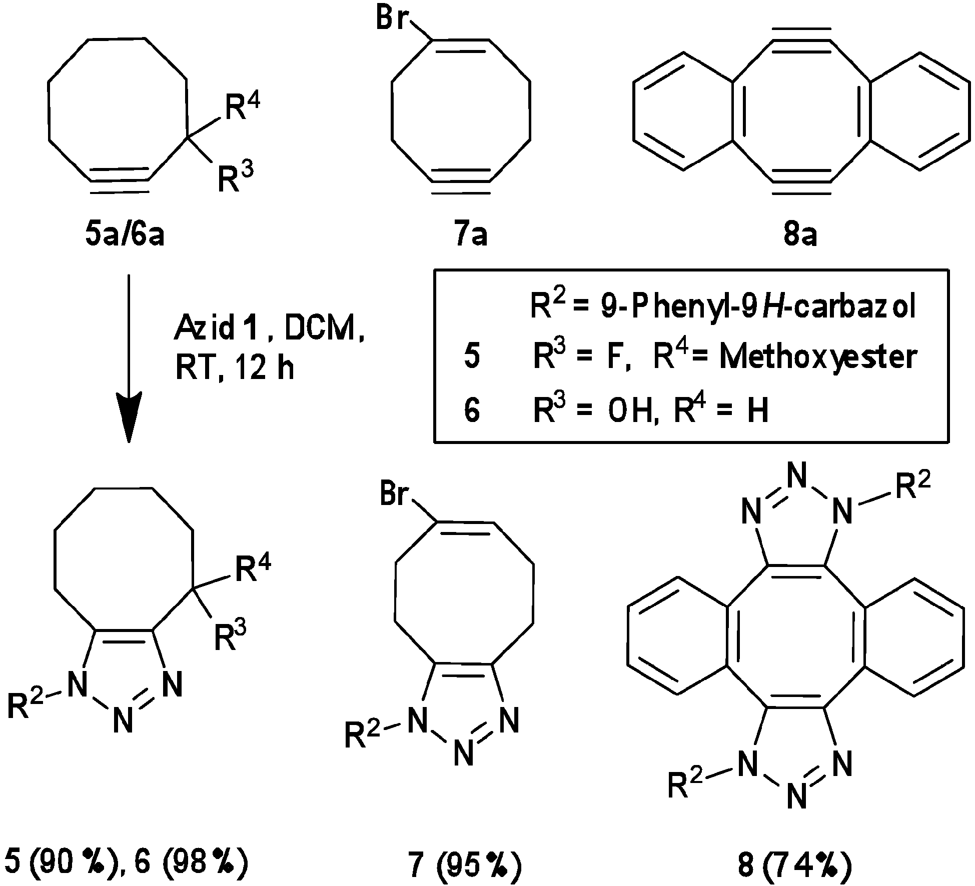

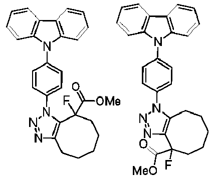

*Methyl 1-(4-(9H-carbazol-9-yl)phenyl)-9-fluoro-4,5,6,7,8,9-hexahydro-1H-cycloocta[d][1,2,3]triazol-9-carboxylat und Methyl-1-(4-(9H-carbazol-9-yl)phenyl)-4-fluoro-4,5,6,7,8,9-hexahydro-1H-cycloocta[d][1,2,3]triazol-4-carboxylat* 5: Zu einer Lösung von Methyl-1-fluorocyclooct-2-ynecarboxylat 5a (0,126 g, 0,684 mmol, 1,00 Äquiv.) in 25 mL DCM wurde 9-(4-Azidophenyl)-9H-carbazol **1** (0,194 g, 0,684 mmol, 1,00 Äquiv.) hinzugefügt. Die Lösung wurde über Nacht bei Raumtemperatur gerührt. Dann wurde das Lösungsmittel entfernt und das Rohprodukt wurde durch Flash-Säulenchromatographie aufgereinigt (Kieselgel, Eluent: Cyclohexan/Ethylacetat 50:1-3:1) um einen weißen Feststoff in 90 %iger Ausbeute hervorzubringen (0,222 g, 0,474 mmol). 0.043 g Carbazolreaktand wurden reisoliert. Mischung von Isomeren: : - R_{f} = 0,36 (3:1 CH/EE). - mp = 92,9 °C. - ¹H-NMR (400 MHz, CDCl₃): δ = 8,20-8.14 (m, 1,99 H, Ar-H), 7,83-7,76 (m, 1,53 H, Ar-H), 7,75-7,60 (m, 0,98 H, Ar-H), 7,69-7,63 (m, 1,56 H, Ar-H), 7,52 - 7,41 (m, 4,07 H, Ar-H), 7,37 - 7,30 (m, 2,00 H, Ar-H), 3,93 (s, 2,32 H, CH₃ (major isomer)), 3,48 (s, 0,73 H, CH₃ (minor isomer)), 3,43-3,31 (m, 0,24 H, CH₂), 3,24-3,08 (m, 1,02 H, CH₂), 3,07-2,94 (m, 0,79 H, CH₂), 2,69-2,47 (m, 2,04 H, CH₂), 2,09-1,92 (m, 1,03 H, CH₂), 1,92-1,70 (m, 3,81 H, CH₂), 1,70-1,53 (m, 2,14 H, CH₂) ppm. - ¹³C-NMR (100 MHz, CDCl₃): δ = 170,5 (C_{quart}, d, ²*J_{C-F}* = 27,3 Hz, C=O), 169,1 (C_{quart}, d, ²*J_{C-F}* = 28,6 Hz, C=O), 142,8 (C_{quart}, C_{Ar}), 142,5 (C_{quart}, C_{Ar}), 140,4 (C_{quart}, C_{Ar}), 140,3 (C_{quart}, C_{Ar}), 139,6 (C_{quart}, C_{Ar}), 139,4 (C_{quart}, C_{Ar}), 135,4 (C_{quart}, d, *³J_{C-F}* = 2,7 Hz, C_{Ar}), 134,6 (C_{quart}, C_{Ar}), 134,2 (C_{quart}, C_{Ar}), 128,8 (+,C_{Ar}), 128,8 (+, C_{Ar}), 127,9 (+, C_{Ar}), 127,3 (+, C_{Ar}), 127,2 (+, C_{Ar}), 126,3 (+, C_{Ar}), 126,2 (+, C_{Ar}), 123,7 (C_{quart}, C_{Ar}), 123,7 (C_{quart}, C_{Ar}), 120,6 (+, C_{Ar}), 120,5 (+, C_{Ar}), 120,5 (+, C_{Ar}), 120,5 (+, C_{Ar}), 109,5 (+, C_{Ar}), 109,5 (+, C_{Ar}), 92,2 (C_{quart}, d, *¹J_{C-F}* = 187,0 Hz, C-F), 53,1 (+, CH₃), 52,9 (+, CH₃), 34,2 (-, d, *²J_{C-F}* = 23.4 Hz, CH₂), 33,8 (-, d, *²J_{C-F}* = 23,4 Hz, CH₂), 26,7 (-, d, *⁴J_{C-F}* = 0,8 Hz, CH₂), 25,8 (-, d, *⁴J_{C-F}* = 1,5 Hz, CH₂), 25,4 (-, CH₂, ), 23,7 (-, CH₂), 22,7 (-, d, *³J_{C-F}* = 6,6 Hz, CH₂), 22,4 (-,CH₂), 21,8 (-, d, *³J_{C-F}* = 4,1 Hz, CH₂), 21,5 (-, CH₂) ppm. - ¹⁹F-NMR (376 MHz, CDCl₃): δ = -146,8 ppm. - IR (ATR): v = 3058 (w), 2928 (w), 2857 (w), 1759 (m), 1600 (w), 1518 (s), 1479 (w), 1450 (s) cm⁻¹. - MS (70 eV, EI), *m*/*z* (%): 468 [M]⁺ (77), 440 [M-N₂]⁺ (57), 381 [C₂₆H₂₂FN₂]⁺ (100), 242 [C₁₈H₁₂N]⁺ (34). - HR-EIMS ber. C₂₈H₂₅FN₄O₂: 468,1962; gef. 468,1962.

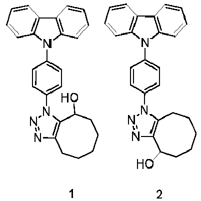

*1-(4-(9H-Carbazol-9-yl)phenyl)-4,5,6,7,8,9-hexahydro-1H-cycloocta[d][1,2,3]triazol-9-ol* **6** (Isomer 1) *und 1-(4-(9H-Carbazol-9-yl)phenyl)-4,5,6,7,8,9-hexahydro-1H-cycloocta[d][1,2,3]triazol-4-ol* **6** (Isomer 2):

Zu einer Lösung von Cyclooct-2-ynol **6a** (0,090 g, 0,725 mmol, 3,00 Äquiv.) in DCM (6 mL) wurde 9-(4-Azidophenyl)-9H-carbazole **1** (0,068 g, 0,239 mmol, 1,00 Äquiv.) hinszugefügt. Die Lösung wurde bei Raumtemperatur für 48 h gerührt. Dann wurde das Lösungsmittel entfernt und das Rohprodukt wurde durch Flash-Säulenchromatographie aufgereinigt (Kieselgel, Eluent: Cyclohexan/Ethylacetat 3:1) um Isomer 1 in 35 %iger (0,029 g, 0,071mmol) und Isomer 2 in 63 %iger Ausbeute (0,052 g, 0,127 mmol) beide als hellgelbe Feststoffe hervorzubringen. (0.010 mg des Carbazolreaktanden konnten reisoliert werden). Isomer 2 wurde komplett aufgereinigt und charakterisiert:
- R_{f} = 0,29 (3:1 CH/EE). - mp = 195,3 °C. - ¹H-NMR (400 MHz, CDCl₃): 5 = 8,20-8,14 (m, 2H, Ar-H), 7,80-7,75 (m, 2H, Ar-H), 7,70-7,65 (m, 2H, Ar-H), 7,51-7,42 (m, 4H, Ar-H), 7,37-7,29 (m, 2H, Ar-H), 5,23 (dd, 1 H, *³J*_{*H*-*H*} = 9,2 Hz, 4,2 Hz, CH-O), 3,33 (bs, 1 H, OH), 3,14-3,03 (m, 1 H, CH₂), 2,94-2,84 (m, 1 H, CH₂), 2,26-2,15 (m, 1 H, CH₂), 2,14-2,04 (m, 1 H, CH₂), 1,83 (q, 2H, *³J*_{*H*-*H*} = 6,3 Hz, CH₂), 1,72 (q, 2H, *³J_{H-H}* = 6,0 Hz, CH₂), 1,67-1,59 (m, 1 H, CH₂), 1,56-1,43 (m, 1 H, CH₂) ppm. - ¹³C-NMR (100 MHz, CDCl₃): δ = 147,5 (C_{quart}), 140,4 (C_{quart}), 139,1 (C_{quart}), 134,7 (C_{quart}), 133,0 (C_{quart}), 127,8 (+, CH), 127,0 (+, CH), 126,2 (+, CH), 123,7 (C_{quart}), 120,5 (+, CH), 120,5 (+, CH), 109,5 (+, CH), 66,9 (+, CH), 35,9 (-, CH₂), 27,2 (-, CH₂), 25,0 (-, CH₂), 22,3 (-, CH₂), 21,4 (-, CH₂) ppm. - IR (ATR): v = 3246 (w), 3067 (w), 2935 (w), 2851 (w), 1599 (w), 1514 (m), 1480 (w), 1450 (m) cm⁻¹. - MS (70 eV, EI), *m*/*z* (%): 408 [M]⁺ (23), 380 [(M-N₂)]⁺ (20), 43 (100). - HR-EIMS: ber. C₂₆H₂₄N₄O: 408,1950; gef. 408,1952.

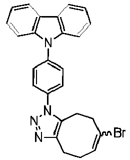

*(E)-9-(4-(6-Bromo-4,5,8,9-tetrahydro-1H-cycloocta[d][1,2,3]triazol-1-yl)phenyl)-9H-carbazol oder (E)-9-(4-(7-Bromo-4,5,8,9-tetrahydro-1H-cycloocta[d][1,2,3]triazol-1-yl)phenyl)-9H-carbazol* 7: Eine Lösung von Dibromocycloocta-1,5-dien (Isomerenmischung) **7a** (280 mg, 1,05 mmol, 1,00 Äquiv.) in Cyclohexan (15 mL) wurde tropfenweise zu einer Suspension von KOtBu (470 mg, 4,20 mmol, 4,00 Äquiv.) und 18-Krone-6 (70 mg, 0,266 mmol, 0,26 Äquiv.) in Cyclohexan (60 mL) unter Argonatmosphäre unter kontinuierlichem Rühren hinzugefügt. Rühren wurde für 110 Minuten fortgeführt (bis das Ausgangsmaterial verbraucht war). Dann wurde die Reaktion durch Zugabe einer gesättigten wässrigen Lösung von NH₄Cl (15 mL) und Wasser (15 mL) gequencht. Die zwei Phasen wurden getrennt und die wässrige Phase wurde mit Ethylacetat extrahiert (3x15 mL). Das Azid **1** (100 mg, 0,35 mmol, 0,33 Äquiv.) wurde zu den kombinierten organischen Phasen hinzugefügt und die resultierende Lösung wurde über Nacht gerührt. Das Lösungsmittel wurde an einem Rotationsverdampfer entfernt und das Rohprodukt wurde durch Flash-Säulenchromatographie aufgereinigt (Kieselgel, Eluent: Cyclohexan/Ethylacetat 4:1) um zwei Isomere (0,080 g, 0,170 mmol (49%) und 0,076 g, 0,162 mmol (46%)) als hellgelbe Feststoffe hervorzubringen.

Charakterisierung des zuerst isolierten Isomers: - R_{f} = 0,18 (4:1 CH/EE). - mp = 181 °C. - ¹H-NMR (400 MHz, CDCl₃): δ = 8,16 (d, 2H, *³J_{H-H} =* 7.7 Hz, Ar-H), 7,79-7,75 (m, 2H, Ar-H), 7,72-7,67 (m, 2H, Ar-H), 7,49-7,42 (m, 4H, Ar-H), 7,36-7,31 (m, 2H, Ar-H), 6,12 (dd, 1 H, *³J_{H-H}* = 8.4 Hz, CH=CBr), 3,36-3,28 (m, 2H, CH₂), 3,12-3,04 (m, 2H, CH₂), 3,02-2,93 (m, 2H, CH₂), 2,74-2,63 (m, 2H, CH₂) ppm. - ¹³C-NMR (100 MHz, CDCl₃): δ = 143,9 (C_{quart}, C_{Ar}), 140,4 (C_{quart}, C_{Ar}), 139,0 (C_{quart}, C_{Ar}), 135,1 (C_{quart}, C_{Ar}), 132,9 (C_{quart}, C_{Ar}), 128,8 (+, CH), 127,8 (+, CH), 126,9 (+, CH) 126,9 (C_{quart}, CBr), 126,2 (+, CH), 123,7 (C_{quart}, C_{Ar}), 120,5 (+, CH), 120,5 (+, CH), 109,6 (+, CH), 39,4 (-, CH₂), 25,4 (-, CH₂), 25,1 (-, CH₂), 24,1 (-, CH₂) ppm. - IR (ATR): v = 3055 (w), 2917 (w), 2848 (w), 1720 (w), 1599 (w), 1517 (s), 1478 (w), 1449 (s) cm⁻¹. - MS (70 eV, EI), *m*/*z* (%): 468/470 [M]⁺ (11/11), 361 [(M-Br-N₂)]⁺ (36), 241 (100), 166 [(C₁₂H₈N)]⁺ (80). - HR-EIMS: ber. C₂₆H₂₈BrN₄: 470,0929; gef. 470,0928. 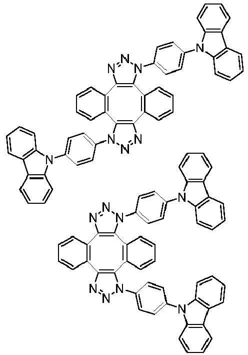 *1,8-bis(4-(9H-Carbazol-9-yl)phenyl)-1,8-dihydrodibenzo[3,4:7,8]cycloocta[1,2-d:5,6-']bis([1,2,3]triazol) und 1,10-bis(4-(9H-Carbazol-9-yl)phenyl)-1,10-dihydrodibenzo[3,4:7,8]cycloocta[1,2-d:5,6-d']bis-([1,2,3]triazol)* **8:** Zu einer Lösung des Diins **8a** (0,033g, 0,165 mmol, 1,00 Äquiv.) in DCM (5 mL) wurde Carbazol **1** (100 mg, 0,352 mmol, 2,13 Äquiv.) hinzugefügt und über Nacht bei Raumtemperatur gerührt. Das Lösungsmittel wurde entfernt und das Rohprodukt wurde durch Flash-Säulenchromatographie aufgereinigt (Kieselgel, Eluent: Cyclohexan/Ethylacetat 10:1) und brachte einen weißen Feststoff in 74 %iger Ausbeute hervor (0,098 g, 0,127mmol).
- R_{f} = 0.20 (10:1 CH/EE). - mp > 250 °C (decomposition) - ¹H-NMR (400 MHz, DMSO-d6): δ = 8,28 (d, 2H, *³J_{H-H} =* 7.7 Hz, Ar-H), 8,20 (d, 2H, *³J_{H-H}* = 7.7 Hz, Ar-H), 7,91-7,86 (m, 4H, Ar-H), 7,86-7,80 (m, 3H, Ar-H), 7,80-7,75 (m, 1 H, Ar-H), 7,71-7,63 (m, 2H, Ar-H), 7,59 (d, 2H, *³J_{H-H} =* 8,7 Hz, Ar-H), 7,52-7,44 (m, 3H, Ar-H), 7,43-7,38 (m, 3H, Ar-H), 7,37-7,30 (m, 6H, Ar-H), 7,28-7,20 (m, 4H, Ar-H) ppm. - ¹³C-NMR (100 MHz, DMSO- d6), δ = 145,1 (C_{quart}, C_{Ar}), 145,1 (C_{quart}, C_{Ar}), 139,7 (C_{quart}, C_{Ar}), 139,6 (C_{quart}, C_{Ar}), 137,7 (C_{quart}, C_{Ar}), 137,5 (C_{quart}, C_{Ar}), 134,6 (Cquart, C_{Ar}), 134,2 (C_{quart}, C_{Ar}), 134,1 (C_{quart}, C_{Ar}), 131,7 (+,C_{Ar}), 131,3 (C_{quart}, C_{Ar}), 131,2 (+,C_{Ar}), 131,0 (+,C_{Ar}), 130,7 (+,C_{Ar}), 130,5 (+,C_{Ar}), 130,2 (C_{quart}, C_{Ar}), 130,0 (+,C_{Ar}), 129,4 (+,C_{Ar}), 129,3 (C_{quart}, C_{Ar}), 129,3 (+,C_{Ar}), 127,8 (+,C_{Ar}), 127,8 (+,C_{Ar}), 127,6 (+,C_{Ar}), 127,4 (C_{quart}, C_{Ar}), 126,8 (+,C_{Ar}), 126,4 (+,C_{Ar}), 126,3 (+,C_{Ar}), 126,1 (C_{quart}, C_{Ar}), 122,9 (C_{quart}, C_{Ar}), 122,8 (C_{quart}, C_{Ar}), 120,6 (+,C_{Ar}), 120,5 (+,C_{Ar}), 120,4 (+,C_{Ar}), 120,3 (+,C_{Ar}), 109,5 (+,C_{Ar}), 109,5 (+,C_{Ar}) ppm. - IR (ATR): v = 3054 (w), 2922 (w), 2848 (w), 1598 (w), 1517 (m), 1478 (w), 1449 (m), 1352 (w), 1334 (w), 1314 (w), 1227 (m) cm⁻¹. - MS (EI, 3-NBA), m/z: 769 [M+H]⁺. - HR-FABMS: ber. [M+H]⁺ C₅₂H₃₃N₈: 769,2828; gef. 769,2830.

Die Ergebnisse von UVVIS-Messungen in Lösung (siehe auch Tabelle 1) beweisen, dass die gewünschte Verdrillung der pi-Systeme nicht nur in Kristallen, sondern auch in Lösung und im amorphen Festkörper auftritt. Die Absorptionsspektren stellen somit die Superposition der Absorptionsspektren der isolierten pi-Systeme dar. Weitere Banden zwischen 300 und 350 nm treten aufgrund von Charge-Transfer-Übergängen auf, die zur Emission von sichtbarem Licht führen. Außerdem finden sich in der Tabelle Daten zur Emissionsfarbe der Verbindungen, die bei den gezeigten Beispielen im blauen Spektralbereich liegt.

**Tabelle 1: Spektroskopische Daten einiger erfindungsgemäßer Verbindungen bei Raumtemperatur.**

| | λ_{abs} (nm) | ε (M⁻¹ cm⁻¹) | λₑₘ (nm | Φ | Stokes shift (nm) |
|---|---|---|---|---|---|
| **1^{b}** | 293 | 21300 ± 600 | | | |
| **2^{b}** | 292 | 15700 ± 500 | 387 | 0.72 ± 0.051 | 95 |
| **3^{a}** | 292 | | 492 | 0.41 ± 0.03 | 200 |
| **3^{b}** | 292 | 15700 ± 500 | 384 | 0.365 ± 0.030 | 92 |
| **3^{c}** | 292 | 23500 ± 800 | 362 | 0.468 ± 0.046 | 70 |
| **3^{e}** | 291 | 19800 ± 700 | 424 | | 132 |
| **4^{a}** | 291 | | 434 | | 143 |
| **4^{d}** | 291 | 4000 ±200 | 467 | 0.027 ± 0.001 | 176 |
| **4^{e}** | 291 | 3800 ±250 | 431 | 0.102 ± 0.005 | 140 |
| **5^{a}** | 293 | | 415 | | 122 |
| **5^{b}** | 293 | 1950 ±50 | 342/356 | 0.311 ± 0.081 | 49/63 |
| **6^{a}** | 293 | | 490 | | 197 |
| **6^{b}** | 293 | 19600 ± 900 | 345/360 | 0.319 ± 0.040 | 52/67 |
| **7^{a}** | 293 | | 492 | | 199 |
| **7^{b}** | 293 | 12400 ± 300 | 345/360 | 0.284 ± 0.058 | 52/67 |
| **7^{c}** | 291 | 32000 ± 7000 | 345/362 | 0.137 ± 0.036 | 54/71 |
| **7^{e}** | 291 | 11100 ± 1000 | 431 | 0.347 ± 0.049 | 140 |
| **7^{g}** | 292 | | 341/357 | | 49/65 |
| **7^{h}** | 291 | | 342/357 | | 51/66 |
| **7ⁱ** | 291 | | 344/360 | | 53/69 |
| **7^{j}** | 291 | | 345/362 | | 54/71 |
| **8^{a}** | 293 | | 416 | | 123 |
| **8^{f}** | 293 | 28000 ± 3000 | 459 | 0.552 ± 0.078 | 166 |

| | | | | | |
|---|---|---|---|---|---|
| ^{a} Feststoff, ^{b} DCM, ^{c} DMF, ^{d} H₂O, ^{e} MeOH, ^{f} DMSO, ^{g} Cyclohexan, Diethylether, ⁱ Ethylacetat, ^{j} DMF | | | | | |

Durch quantenchemische Rechnungen (DFT, B3-LYP/def2-TZVP Level)¹⁸ konnten die Grenzorbitale visualisiert werden, wie in Figuren 5 bis 7 dargestellt ist. Wie gewünscht liegt das HOMO auf der elektronenspendenden Donorgruppe, während das LUMO auf der elektronenziehenden Akzeptorgruppe liegt.

**Tabelle 2: B3LYP/def2-TZVP HOMO und LUMO Energien in eV im Grundzustand, links: 2,3,7 Gasphase und rechts: 3 in Dichlormethan und Methanol (COSMO).**

| | **2** | **3** | **7** | | | **3 (CH₂Cl₂)** | **3 (MeOH)** |
|---|---|---|---|---|---|---|---|
| HOMO | -5,72 | -5,71 | -5,76 | | HOMO | -5,70 | -5,70 |
| LUMO | -1,62 | -1,52 | -1,38 | | LUMO | -1,42 | -1,41 |

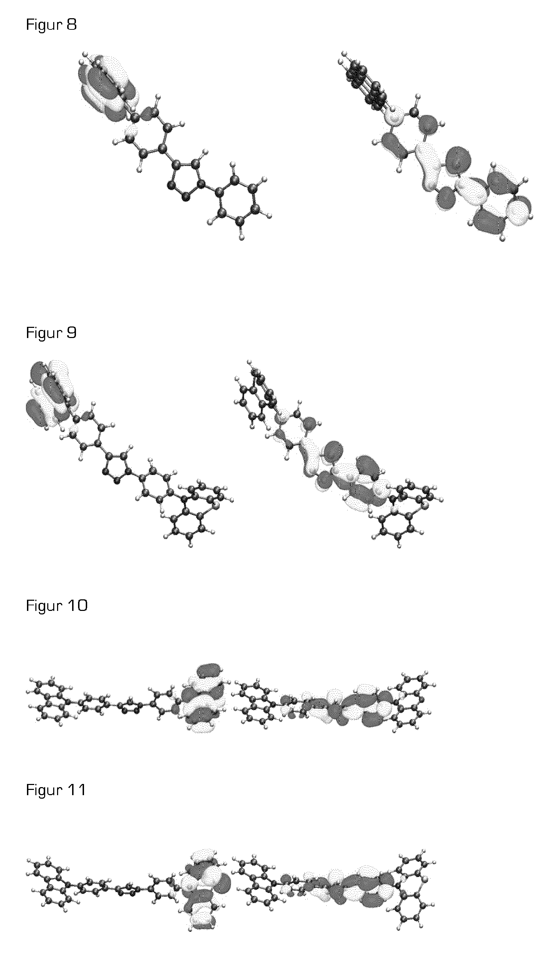

Weitere Beispiele für erfindungsgemäße Verbindungen (om303, om306 bis om308, om310 bis om311) wurden mit bp86-def2svp und b3lyp-def2svp berechnet und zeigen klar, dass das HOMO auf der elektronenspendenden Donorgruppe liegt, während das LUMO auf der elektronenziehenden Akzeptorgruppe liegt. (siehe Figuren 8 bis 13).

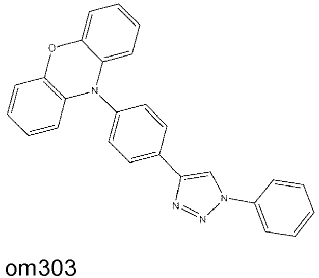

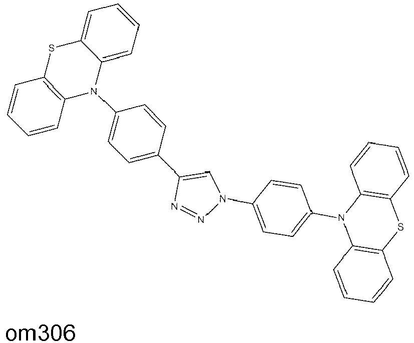

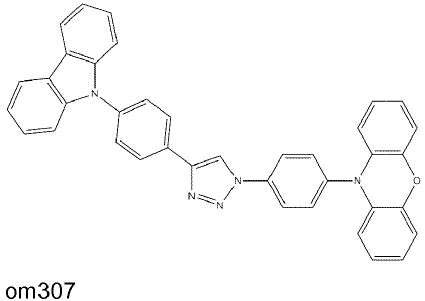

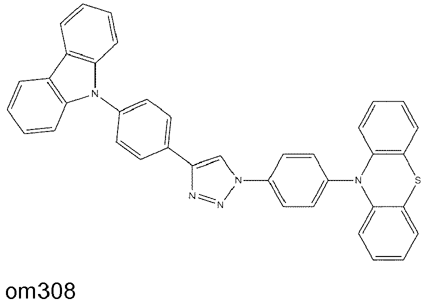

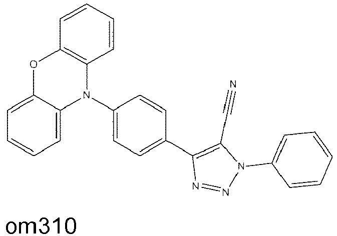

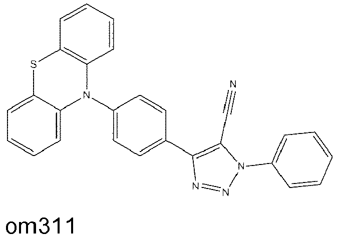

### Einsatz als Lumineszenzmarker

Aufgrund der besonders vorteilhaften Eigenschaften lassen sich die erfindungsgemäßen Verbindungen in einem Aspekt der Erfindung auch in der Biologie oder Medizin, insbesondere in einem Verfahren zur Markierung von Zellen, beispielsweise als Lumineszenzmarker, einsetzen. Die Eignung für diese Anwendung wurde durch Konfokalmikroskopie nachgewiesen. Hierzu wurden HeLa-Zellen mit den Molekülen 2 und 7 markiert und mittels Laser zur Lumineszenz angeregt. Wie in Figur 14 gezeigt ist, wurden die Leuchtstoffe im endosomal-lysosomalen System einer Zelle bevorzugt aufgenommen.

### Figuren

**Figur 1****:** Prinzipieller, schematische Aufbau eines OLEDs. Die Abbildung ist nicht maßstabsgerecht gezeichnet.
Figur 2: Beispiele für Dienophile und Dipolarophile und entsprechende Diene und 1,3-Dipole
**Figur 3****:** Molekülstruktur von **2.**
**Figur 4****:** Molekülstruktur von 3.
**Figur 5****:** HOMO (links) und LUMO (rechts) Grenzorbitalabbildungen der Verbindung 2.
**Figur 6****:** HOMO (links) und LUMO (rechts) Grenzorbitalabbildungen der Verbindung 3.
**Figur 7****:** HOMO (links) und LUMO (rechts) Grenzorbitalabbildungen der Verbindung 7.
**Figur 8****:** HOMO (links) und LUMO (rechts) Grenzorbitalabbildungen der Verbindung om303.
**Figur 9****:** HOMO (links) und LUMO (rechts) Grenzorbitalabbildungen der Verbindung om306.
**Figur 10****:** HOMO (links) und LUMO (rechts) Grenzorbitalabbildungen der Verbindung om307.
**Figur 11****:** HOMO (links) und LUMO (rechts) Grenzorbitalabbildungen der Verbindung om308.
**Figur 12****:** HOMO (links) und LUMO (rechts) Grenzorbitalabbildungen der Verbindung om310.
**Figur 13****:** HOMO (links) und LUMO (rechts) Grenzorbitalabbildungen der Verbindung om311.
**Figur 14****:** Konvokalmikroskopieaufnahme.

10⁴ HeLa Zellen wurden inkubiert mit einer 30 µmol/l Lösung von **2 (E-H)** oder **7 (I-L)** in Dulbecco's Modified Eagle Medium (DMEM) (20 mmol/l Stammlösung in DMSO, frisch verdünnt 666 x in DMEM) bei 37 °C für 24 h und anschließend Fluoreszenzonvokalmikroskopie unterworfen unter Verwendung eines Leica SP5-TCS (DMI6000) Inversmikroskops. Objectiv: HCX PL APO CS 63.0x1.20 WATER UV. Anregungswellenlänge: 351 nm. 1. Säule: Emissionbandbreite: 417 - 468 nm **(A, E, I**), 2. Säule **(B, F, J):** Emissionsbandbreite: 518 - 724 nm, 3. Säule **(C, G, K):** Brightfield, 4. Säule **(D, H,** L): Merge: **A-D,** Kontrollzellen, nur DMSO, **E-H,** Verbindung **2; I-L** Verbindung 7.

## Patentansprüche

1. Organisches Molekül, aufweisend eine Struktur der Formel A 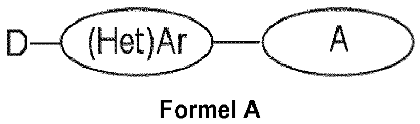 mit
(Het)Ar = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen,
D = eine chemisch gebundene Donatorgruppe mit elektronenschiebenden Eigenschaften und
A = ein unsubstituierter oder substituierter 5- oder 6-gliedriger Ring optional mit mindestens einem Heteroatom, der aus einer [i+j]-Cycloaddition im Falle eines 5-Rings aus einem Dipolarophil und einem 1,3-Dipol und im Fall eines 6-Rings aus einem Dien und einem Dienophil gebildet werden kann.

2. Organisches Molekül nach Anspruch 1, wobei das Molekül als dimeres System eine Struktur der Formel A* aufweist, 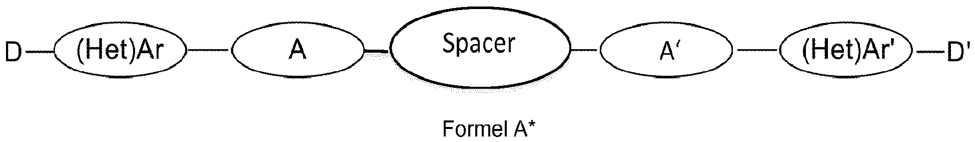 mit
(Het)Ar = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen,
(Het)Ar' = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen, die gleich oder verschieden sein kann zu (Het)Ar,
D und D' = unabhängig voneinander eine chemisch gebundene Donatorgruppe mit elektronenschiebenden Eigenschaften und
A und A' = unabhängig von einander ein unsubstituierter oder substituierter 5- oder 6-gliederiger Ring (optional mit mindestens einem Heteroatom), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und
Spacer = ein substituiertes oder unsubstituiertes aromatisches oder heteroaromatisches Ringsystem mit 5 bis 60 aromatischen Ringatomen.

3. Organisches Molekül nach Anspruch 1, aufweisend eine Struktur der Formel A' 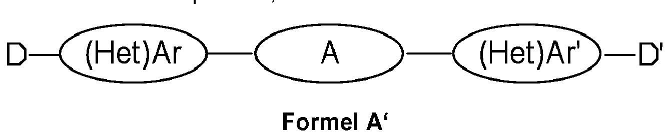 mit
(Het)Ar = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen,
(Het)Ar' = eine konjugierte organische Gruppe, die ausgewählt ist aus der Gruppe bestehend aus unsubstituierten und substituierten aromatischen, heteroaromatischen und konjugierten, gegenüber cistrans-Isomerisierung fixierten Doppelbindungen, die gleich oder verschieden sein kann zu (Het)Ar,
D und D' = unabhängig voneinander eine chemisch gebundene Donatorgruppe mit elektronenschiebenden Eigenschaften und
A = ein unsubstituierter oder substituierter 5- oder 6-gliederiger Ring (optional mit mindestens einem Heteroatom), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann.

4. Organisches Molekül nach Anspruch 1 bis 3, wobei das Organische Molekül
- einen ΔE(S₁-T₁)-Wert zwischen dem untersten angeregten Singulett (S₁)- und dem darunter liegenden Triplett (T₁)-Zustand von kleiner als 5000 cm⁻¹, bevorzugt kleiner als 3000 cm⁻¹ aufweist; und/oder
- eine Emissionslebensdauer von höchstens 50 µs aufweist;

5. Organisches Molekül nach Anspruch 1 bis 4, wobei (Het)Ar, (Het)Ar', A, A' D und/oder D' mindestens einen Substituenten zur Erhöhung der Löslichkeit des organischen Moleküls in einem organischen Lösungsmittel aufweisen wobei der Substituenten zur Erhöhung der Löslichkeit bevorzugt ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
- verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

6. Organisches Molekül nach Anspruch 1 bis 5, wobei (Het)Ar und (Het)Ar' unabhängig voneinander ein substituierter oder unsubstituierter Phenylring ist.

7. Organisches Molekül nach Anspruch 1 bis 6, wobei mindestens einer der Substituenten A, A', D oder D' ein Heteroatom X, insbesondere ausgewählt aus der Gruppe bestehend aus N, O, P, S, Se, aufweist, über das der Substituent kovalent an (Het)Ar oder (Het)Ar' gebunden ist.

8. Organisches Molekül nach Anspruch 1 oder 4 bis 7, aufweisend eine Struktur der Formel C, 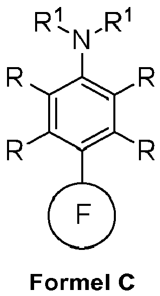 mit
F = ein unsubstituierter oder substituierter 5- oder 6-gliederiger Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 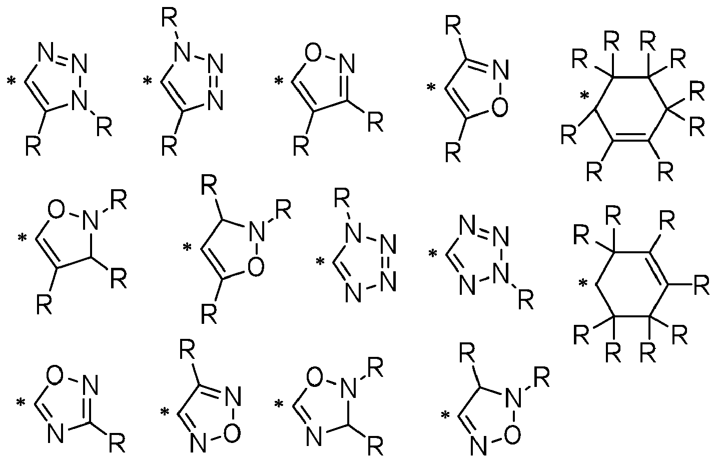 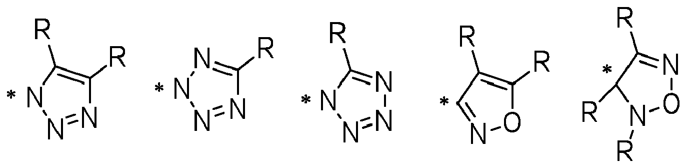 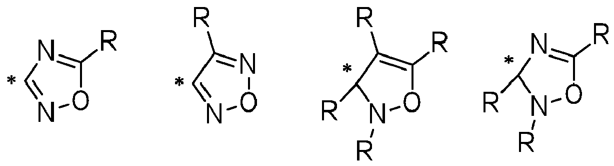 wobei
jedes R und R¹ bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R¹ auch miteinander ein mono-oder polycyclisches, aliphatisches, aromatisches und/oder benzoannelliertes Ringsystem bilden; R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
und die Verknüpfung zur Phenyleinheit an der mit * markierten Stelle stattfindet.

9. Organisches Molekül nach Anspruch 3 bis 7, aufweisend eine Struktur der Formel C', 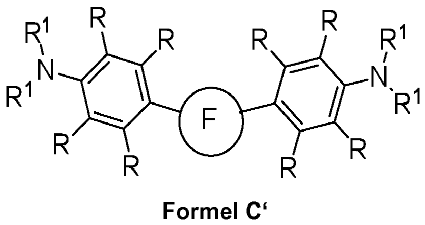 mit F = ein unsubstituierter oder substituierter 5- oder 6-gliederiger Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 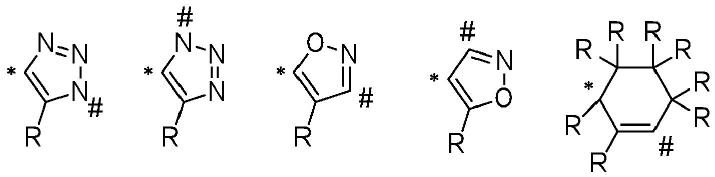 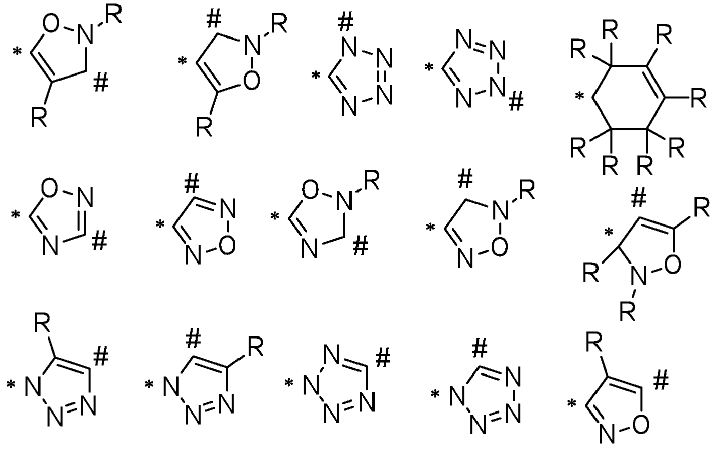 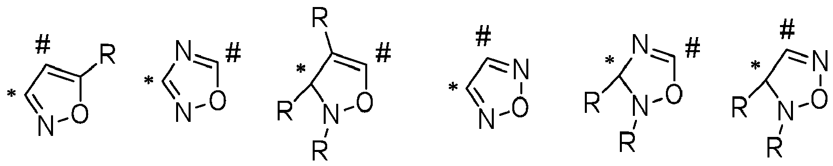 wobei
jedes R und R¹ bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R¹ auch miteinander ein mono-oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
und die Verknüpfung zu den Phenyleinheiten an den mit * und # markierten Stellen stattfindet.

10. Organisches Molekül nach Anspruch 2 oder 4 bis 7, aufweisend eine Struktur der Formel C*, 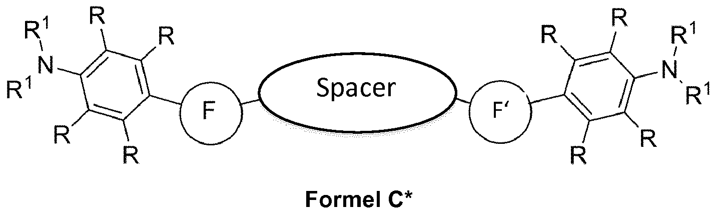 mit
Spacer = ein substituiertes oder unsubstituiertes aromatisches oder heteroaromatisches Ringsystem mit 5 bis 60 aromatischen Ringatomen;
F, F' = unabhängig von einander ein unsubstituierter oder substituierter 5- oder 6-gliederiger Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 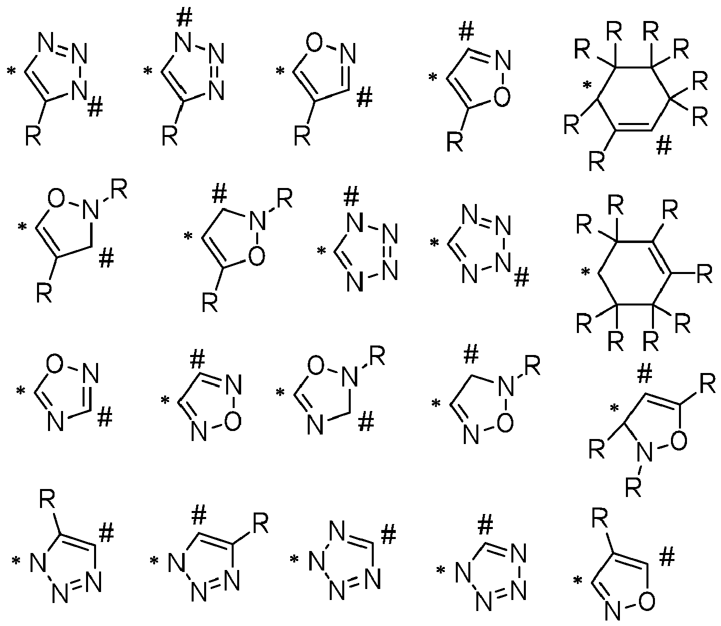 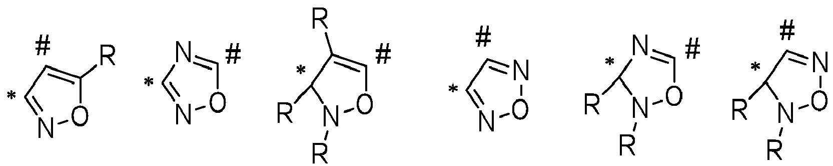 wobei jedes R und R¹ bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R und R¹ auch miteinander ein mono-oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden; und die Verknüpfung zum Spacer und zu den Phenyleinheiten an den mit * und # markierten Stellen stattfindet.

11. Organisches Molekül nach Anspruch 1 oder 4 bis 8, aufweisend eine Struktur der Formel D, 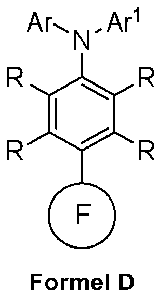 mit
F = ein unsubstituierter oder substituierter 5- oder 6-gliederiger Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 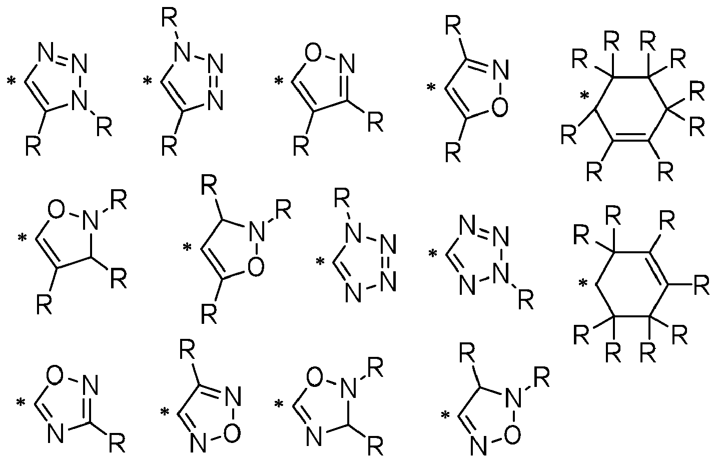 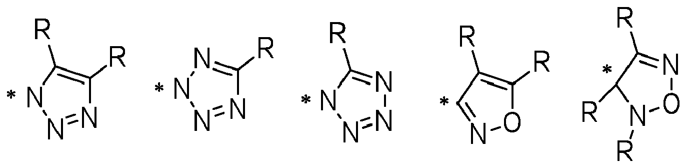 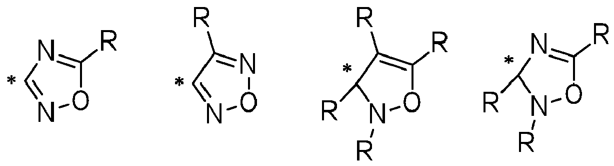 wobei
jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
die Verknüpfung zur Phenyleinheit an der mit * markierten Stelle stattfindet;
und NArAr¹ = ein Donor, mit Ar, Ar¹ = unabhängig voneinander ein aromatisches oder heteroaromatisches Ringsystem mit 5 - 60 aromatischen Ringatomen, das optional jeweils durch einen oder mehrere Reste R substituiert ist und das über beliebige Positionen am Aromaten oder Heteroaromaten verknüpft sein kann; Ar und Ar¹ sind optional miteinander anelliert oder über eine Einheit E miteinander verbunden (z. B. Carbazol, Phenoxazin, Phenothiazin); E steht für eine kovalente Einfachbindung oder für eine organische Brücke, die eine substituierte oder unsubstituierte Alkylen-, Alkenylen-, Alkinylen- oder Arylen-Gruppe oder eine Kombination dieser, oder -O-, -NR-, -C=CR₂,-C=NR, -SiR₂- -S-, -S(O)-, -S(O)₂-, durch O unterbrochene Alkyl- (unverzweigt, verzweigt oder zyklisch), Heteroalkyl-, Aryl-, Heteroaryl-, Alkenyl-Gruppen, Phenyl- und substituierte Phenyleinheiten ist.

12. Organisches Molekül nach Anspruch 3 bis 7 oder 9, aufweisend eine Struktur der Formel D', 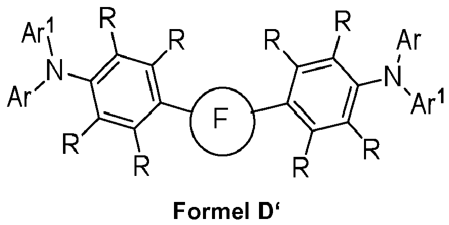 mit
F = ein unsubstituierter oder substituierter 5- oder 6-gliederiger Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 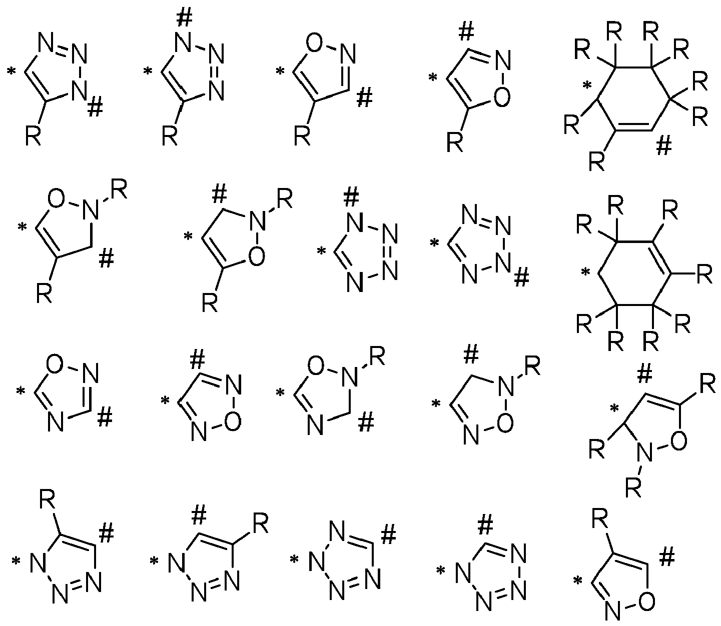 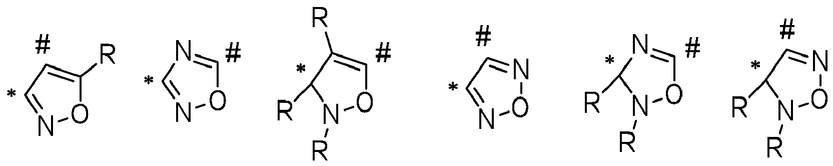 wobei jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
die Verknüpfung zu den Phenyleinheiten an den mit * und # markierten Stellen stattfindet;
und NArAr¹ = ein Donor, mit Ar, Ar¹ = unabhängig voneinander ein aromatisches oder heteroaromatisches Ringsystem mit 5 - 60 aromatischen Ringatomen, das jeweils durch einen oder mehrere Reste R substituiert sein kann und das über beliebige Positionen am Aromaten bzw. Heteroaromaten verknüpft sein kann; Ar und Ar¹ können auch miteinander anelliert oder über eine Einheit E miteinander verbunden sein (z. B. Carbazol, Phenoxazin, Phenothiazin); E steht für eine kovalente Einfachbindung oder für eine organische Brücke, die eine substituierte oder unsubstituierte Alkylen-, Alkenylen-, Alkinylen- oder Arylen-Gruppe oder eine Kombination dieser, oder -O-, -NR-,-C=CR₂, -C=NR, -SiR₂- -S-, -S(O)-, -S(O)₂-, durch O unterbrochene Alkyl- (unverzweigt, verzweigt oder zyklisch), Heteroalkyl-, Aryl-, Heteroaryl-, Alkenyl-Gruppen, Phenyl- und substituierte Phenyleinheiten ist.

13. Organisches Molekül nach Anspruch 2, 4 bis 7 oder 10, aufweisend eine Struktur der Formel D*, 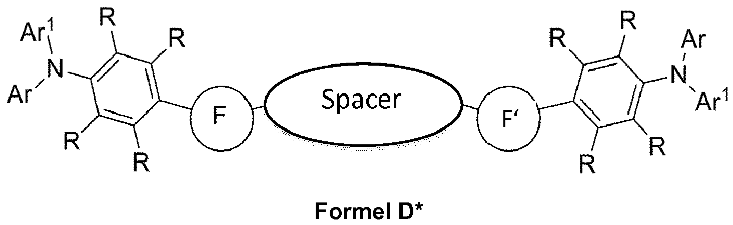 mit
F, F' = unabhängig von einander ein unsubstituierter oder substituierter 5- oder 6-gliederiger Ring (mit optional Heteroatomen), der aus einer [i+j]-Cycloaddition im Falle eines 5-Rings aus einem Dipolarophil und einem 1,3-Dipol und im Fall eines 6-Rings aus einem Dien und einem Dienophil gebildet werden kann und ausgewählt ist aus der Gruppe bestehend aus 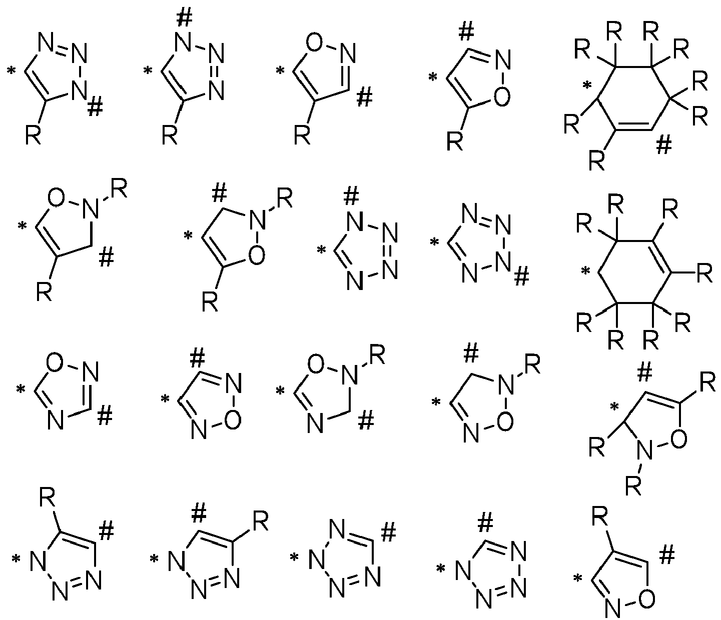 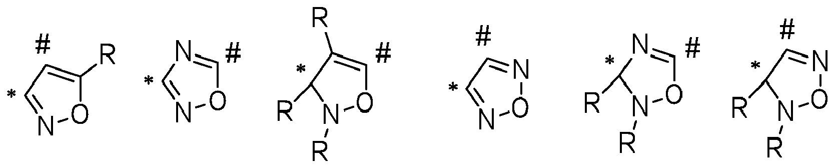 wobei
jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
die Verknüpfung zum Spacer und zu den Phenyleinheiten an den mit * und # markierten Stellen stattfindet;
und NArAr¹ = ein Donor, mit Ar, Ar¹ = unabhängig voneinander ein aromatisches oder heteroaromatisches Ringsystem mit 5 - 60 aromatischen Ringatomen, das jeweils durch einen oder mehrere Reste R substituiert sein kann und das über beliebige Positionen am Aromaten bzw. Heteroaromaten verknüpft sein kann; Ar und Ar¹ können auch miteinander anelliert oder über eine Einheit E miteinander verbunden sein (z. B. Carbazol, Phenoxazin, Phenothiazin); E steht für eine kovalente Einfachbindung oder für eine organische Brücke, die eine substituierte oder unsubstituierte Alkylen-, Alkenylen-, Alkinylen- oder Arylen-Gruppe oder eine Kombination dieser, oder -O-, -NR-,-C=CR₂, -C=NR, -SiR₂- -S-, -S(O)-, -S(O)₂-, durch O unterbrochene Alkyl- (unverzweigt, verzweigt oder zyklisch), Heteroalkyl-, Aryl-, Heteroaryl-, Alkenyl-Gruppen, Phenyl- und substituierte Phenyleinheiten ist.

14. Organisches Molekül nach Anspruch 1, 4 bis 8 oder 11, aufweisend eine Struktur der Formel E, 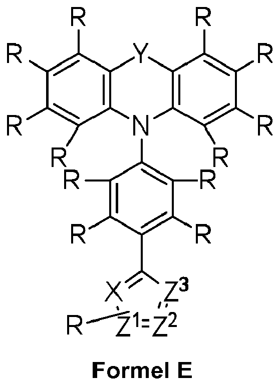 mit
X = ausgewählt aus der Gruppe bestehend aus dem Fragment CR und N;
Y = kovalente Einfachbindung oder ausgewählt aus der Gruppe bestehend aus O, S, NR, CRR', C=CRR', C=NR und SIRR';
Z¹-Z³ = jeweils unabhängig voneinander ausgewählt aus der Gruppe bestehend aus dem Fragment CRR', CR, NR, N und O, wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen X und Z¹ immer eine Einfachbindung vorhanden ist;
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)_{R}³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

15. Organisches Molekül nach Anspruch 1, 4 bis 8 oder 11, aufweisend eine Struktur der Formel F, 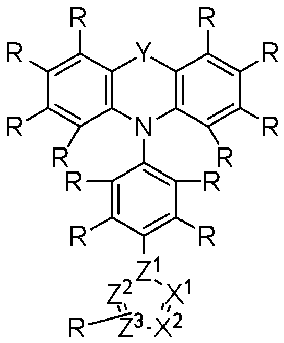 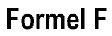 mit
X¹, X² = unabhängig voneinander ausgewählt aus der Gruppe bestehend aus dem Fragment CR und N; Y = kovalente Einfachbindung oder ausgewählt aus der Gruppe bestehend aus O, S, NR, CRR', C=CRR', C=NR und SIRR';
Z¹-Z³ = jeweils unabhängig voneinander ausgewählt aus der Gruppe bestehend aus dem Fragment CR, C, N, NR, O. wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X¹ immer eine Einfachbindung vorhanden ist;
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)_{R}³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

16. Organisches Molekül nach Anspruch 3 bis 7, 9 oder 12, aufweisend eine Struktur der Formel G, 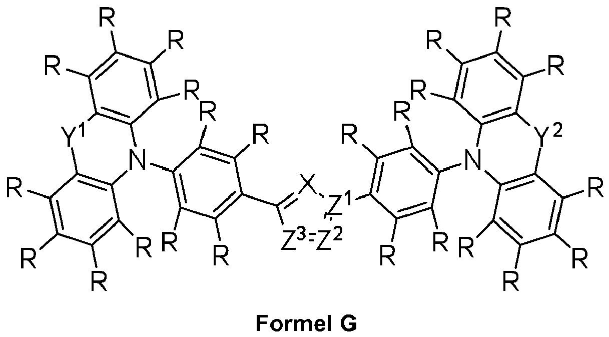 mit
X = ausgewählt aus der Gruppe bestehend aus N und dem Fragment CR;
Y¹, Y² = unabhängig voneinander ausgewählt aus der Gruppe bestehend aus einer direkten Bindung, O, S, NR, CRR', C=CRR', C=NR und SIRR';
Z¹ = ausgewählt aus der Gruppe bestehend aus C, N und dem Fragment CR;
Z² = ausgewählt aus der Gruppe bestehend aus N und dem Fragment NR;
Z³ = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X immer eine Einfachbindung vorhanden ist;
wobei
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)_{R}³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

17. Organisches Molekül nach Anspruch 3 bis 7, 9 oder 12, aufweisend eine Struktur der Formel H, 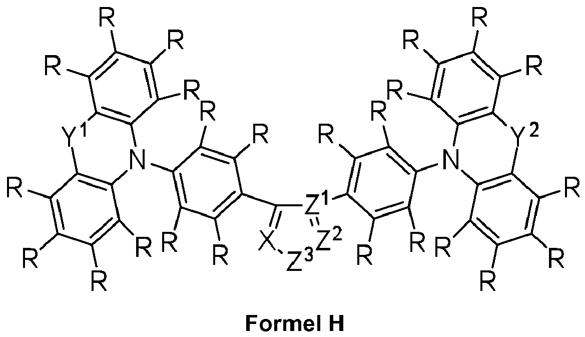 mit
X = ausgewählt aus der Gruppe bestehend aus N und dem Fragment CR;
Y¹, Y² = unabhängig voneinander ausgewählt aus der Gruppe bestehend aus einer direkten Bindung, O, S, NR, CRR', C=CRR', C=NR und SIRR';
Z¹ = ausgewählt aus der Gruppe bestehend aus C, N und dem Fragment CR;
Z² = ausgewählt aus der Gruppe bestehend aus N und dem Fragment NR;
Z³ = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z³ und X immer eine Einfachbindung vorhanden ist;
wobei
jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder
eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

18. Organisches Molekül nach Anspruch 2, 4 bis 7, 10 oder 13, aufweisend eine Struktur der Formel I, 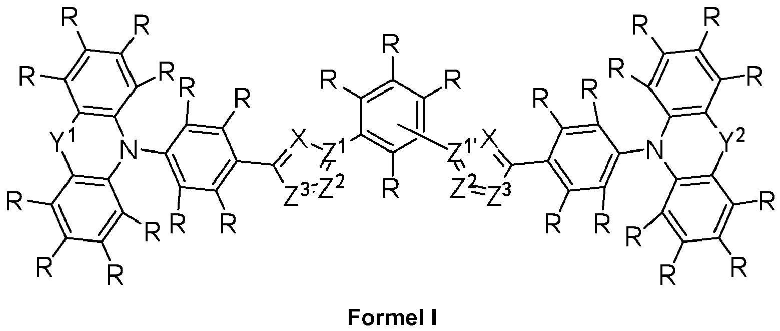 mit
X = ausgewählt aus der Gruppe bestehend aus N und dem Fragment CR;
Y¹, Y² = unabhängig voneinander eine kovalente Einfachbindung oder ausgewählt aus der Gruppe bestehend aus O, S, NR, CRR', C=CRR', C=NR und SIRR';
Z¹ = ausgewählt aus der Gruppe bestehend aus C, N und dem Fragment CR;
Z² = ausgewählt aus der Gruppe bestehend aus N und dem Fragment NR;
Z3 = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X immer eine Einfachbindung vorhanden ist, und die Anbindung von Z¹' an den zentralen Phenylring in ortho-, meta-, und para-Position zu Z¹ sein kann, bevorzugt in meta- oder para-Position;
wobei
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)_{R}³, P(=O)(R³)₂, S(=O)R², S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

19. Organisches Molekül nach Anspruch 2, 4 bis 7, 10 oder 13, aufweisend eine Struktur der Formel K, 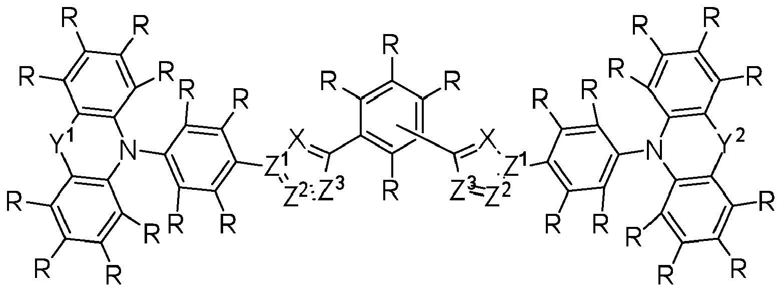 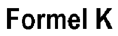 mit
X = ausgewählt aus der Gruppe bestehend aus N und dem Fragment CR;
Y¹, Y² = unabhängig voneinander eine kovalente Einfachbindung oder ausgewählt aus der Gruppe bestehend aus O, S, NR, CRR', C=CRR', C=NR und SIRR';
Z¹ = ausgewählt aus der Gruppe bestehend aus C, N und dem Fragment CR;
Z² = ausgewählt aus der Gruppe bestehend aus N und dem Fragment NR;
Z³ = ausgewählt aus der Gruppe bestehend aus N und O;
wobei je nach Fragment zwischen Z¹ und Z² entweder eine Einfach- oder eine Doppelbindung und zwischen Z² und Z³ entweder eine Einfach- oder eine Doppelbindung vorhanden ist, und zwischen Z¹ und X immer eine Einfachbindung vorhanden ist, und die zwei 5-Ringe in ortho-, meta-, und para-Position zueinander stehen können;
wobei
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme; dabei können zwei oder mehrere dieser Substituenten R¹ auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)_{R}³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C=C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

20. Verfahren zur Herstellung eines Organischen Moleküls nach Anspruch 1 bis 19 aufweisend eine [i+j]-Cycloaddition (Clickreaktion) der mit einer Donatorgruppe D bzw. D' versehenen Het(Ar) oder (Het)Ar'-Gruppe, die eine zur Clickreaktion befähigte Gruppe ausgewählt aus einem Dipolarophil, 1,3-Dipol, Dienophil und Dien trägt mit einer entsprechenden komplementären Gruppe, wobei ein unsubstituierter oder substituierter 5- oder 6-gliedriger Ring A oder A' ausgebildet wird.

21. Verwendung eines Organischen Moleküls nach Anspruch 1 bis 19 als Emitter oder Absorber in einem optoelektronischen Bauelement, das durch ein Vakuumverdampfungsverfahren oder aus Lösung hergestellt wird.

22. Optoelektronisches Bauelement, aufweisend ein organisches Molekül nach Anspruch 1 bis 19.

23. Lichtemittierendes Material, aufweisend ein organisches Molekül nach Anspruch 1 bis 19 und ein Hostmaterial, wobei die Triplett (T1)- und Singulett (S1)-Energieniveaus des Hostmaterials energetisch höher liegen als die Triplett (T1)- und Singulett (S1)-Energieniveaus des organischen Moleküls, und wobei das organische Molekül Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 3000 cm⁻¹ aufweist.

24. Verfahren zur Herstellung eines optoelektronischen Bauelements, wobei ein organisches Molekül nach Anspruch 1 bis 19 verwendet wird.

25. Verwendung eines organischen Moleküls nach Anspruch 1 bis 20 in der Biologie oder Medizin, insbesondere in einem Verfahren zum Markieren von Zellen.
